# EUROPEAN PATENT SPECIFICATION

(11) **EP 3 132 474 B1**
(45) Date of publication and mention of the grant of the patent: **11.03.2020**
(21) Application number: 15712406.6
(22) Date of filing: 18.03.2015
(51) Int. Cl.: H01L 51/46, C01B 32/05, C08G 61/12, H01L 31/00

(54) **HOLE CONDUCTION LAYER**
LOCHLEITUNGSSCHICHT
COUCHE DE CONDUCTION PAR TROUS

(30) Priority: 18.03.2014 GB 201404840
(43) Date of publication of application: 22.02.2017
(73) Proprietor: Oxford University Innovation Limited, Botley Oxford OX2 0JB (GB)
(72) Inventor: SNAITH, Henry James, Oxford Oxfordshire OX1 3PU (GB); NICHOLAS, Robert John, Oxford Oxfordshire OX1 3PU (GB); HABISREUTINGER, Severin Niklas, Oxford Oxfordshire OX1 3PU (GB)
(74) Representative: J A Kemp LLP
(86) International application number: PCT/GB2015/050792
(87) International publication number: WO 2015/140548

(56) References cited:
- EP-A1- 2 693 503
- WO-A2-2010/030511
- US-A1- 2009 085 012
- US-A1- 2009 205 713
- US-A1- 2012 007 046

## Description

### FIELD OF THE INVENTION

The invention relates to a semiconductor device comprising a component for transporting charge. The invention also relates to a process for producing a semiconductor device comprising a component for transporting charge.

### BACKGROUND TO THE INVENTION

The conversion of solar energy into electricity is one of the most promising routes to meeting the increasing energy demands of future generations without negatively impacting on the global climate. Cost and energy input involved in the manufacturing process are essential challenges faced by the conventional inorganic solar cell industry, which can both be overcome by newly emerging thin-film and organic-inorganic hybrid approaches. Important breakthroughs in device performance have recently been achieved through the use of semiconducting organic-inorganic perovskite absorbers. Remarkably, the mixed halide perovskite CH₃NH₃PbI₃₋ₓClₓ can function both as wide-range absorber and as ambipolar charge transporter (Lee, M. M., Teuscher, J., Miyasaka, T., Murakami, T. N. & Snaith, H. J. Efficient hybrid solar cells based on meso-superstructured organometal halide perovskites. Science. 338, 643-7 (2012)). The latter property allows it to be coated onto an electronically inert alumina scaffold resulting in 'meso-superstructured solar cells' (MSSCs) in which charge generation and transport both happen within the perovskite material and yield power power-conversion efficiencies of up to 12.3% (Ball, J. M., Lee, M. M., Hey, A. & Snaith, H. J. Low-temperature processed meso-superstructured to thin-film perovskite solar cells. Energy Environ. Sci. 6, 1739 (2013)). Progressing further, thin-film perovskite solar cells, comprising a solid layer of perovskite with no mesoporosity have exhibited solar to electrical power conversion efficiencies of over 15% (Liu, M., Johnston, M. B., Snaith, H. J., Efficient planar heterojunction perovskite solar cells by vapour deposition. Nature 501, 395-398 (2013)). Following light absorption, charge is generated within the bulk of the perovskite absorber, but efficient charge extraction with low losses requires selective contact of the perovskite with positive (p) and negative (n) contact materials, which exhibit low resistive losses. It is known to employ a p-type organic hole-conductor, 2,2',*7,-7'*-tetrakis(*N,N-*di-p-methoxyphenylamine)-9,9'-spirobifluorene (spiro-OMeTAD), which was first introduced in solid-state dye-sensitized solar cells for its high solubility and amorphous nature. These properties are ideal for infiltration into mesoporous films, but are less relevant for use in planar heterojunction solar cells. The low intrinsic charge carrier mobility of amorphous organic hole-conductors can be overcome to a certain extent by increasing the carrier density by oxidative doping. However, the doped hole-conductors generally absorb light strongly in the visible to near IR region, contributing parasitic absorption losses to the solar cell, and for spiro-OMeTAD a maximally feasible conductivity of less than 10⁻⁴ Scm⁻¹ may still introduce resistive losses in the perovskite solar cells. It is desirable, therefore, to provide a component for transporting charge with increased charge carrier mobilities and which meanwhile does not increase absorption losses.

Another key requirement for long term semiconductor device operation is thermal stability. In particular, semiconductor devices often need to withstand high temperatures or repeated thermal cycles. For instance, solar cells must be able to withstand both temperatures of up to 85°C for prolonged periods of time and also a large number of thermal cycles throughout their lifetime from between -40°C to +85°C. For this to be possible, the layered structure of the solar cell must be able to sustain temperatures up to 85°C. In addition, the material must also be as insensitive to moisture and oxygen as possible, in order to prolong the lifetime of the cell. The amount of water vapor and oxygen close to the photoactive layers of the solar cell can be significantly reduced by externally encapsulating of the cells in, for instance, a glass laminate. However, water vapour may still transport through the seals over time, and intrinsically resilient photoactive layers are preferable.

Considering crystalline silicon solar cells as an example, silicon wafers are cleaned and prepared by rinsing a series of etching solutions including HF, piranha rinse (sulfuric acid with hydrogen peroxide) and deionized water. After this etch and clean, the surface of the silicon wafer needs to be coated with a specific pacifying agent or taken to a completely inert atmosphere (e.g. a vacuum) within a few minutes. A great achievement was made when amorphous silicon was found to not only pacify the defect states on the silicon wafer, but also to act as a very effective charge collection layer for crystalline silicon solar cells. This lead to the development of HIT (heterojunction with intrinsic thin layer) cells and very efficient and stable crystalline silicon solar cells. Known perovskite solar cells are generally constructed with a layer of p-type organic semiconductor on top of a solid perovskite layer. On testing the thermal stability of perovskite CH₃NH₃PbI₃₋ₓClₓ films, it has been noticed that the films discolour very quickly when heated at 80°C for a long period of time in air. The discoloration from dark brown to yellow is accompanied by a change in the X-ray diffraction (XRD) pattern, which indicates a transformation from CH₃NH₃PbI₃₋ₓClₓ to PbI₂. This is consistent with loss of the CH₃NH₃⁺ cation and excess iodine, both of which are quite volatile. Hence, one previously unknown requirement for the hole-transporter layer may be to encapsulate the top of the perovskite film and prevent loss of the more volatile components from the perovskite crystal during heating. Coating the perovskite films with the current known organic charge transport materials does not prevent this degradation from occurring. The instability of known charge transport components is therefore a problem.

It is thus an object of the invention to provide a charge transport component for use in a semiconductor device, which charge transport component has good charge carrier mobilities and which does not cause significant light absorption losses in the device. It is another object of the invention to overcome the thermal instability found for known charge transport components and also to provide a charge transporting component that can help to prevent degradation of other components in a device.

Document US2009205713 (A) discloses organic/inorganic hybrid photovoltaic devices comprising carbon nanotubes functionalized with semiconducting polymers.

### SUMMARY OF THE INVENTION

Carbon nanotubes (CNTs), for instance single-walled carbon nanotubes (SWNTs), exhibit outstanding charge carrier transport characteristics. They have been previously embedded in other semiconducting polymers, to improve the charge transport within the semiconducting polymer phase, and charge collection in organic and hybrid solar cells (Kyrylyuk, A. V, Hermant, M. C., Schilling, T., Klumperman, B., Koning, C. E. & van der Schoot, P. Controlling electrical percolation in multicomponent carbon nanotube dispersions. Nat. Nanotechnol. 6, 364-9 (2011)). Although relatively promising results have been obtained, optimum device performance has only been observed with very low fractions of SWNTs, and whether the SWNTs are serving an electronic function or simply advantageously enhancing the crystallization of the polymer hole-conductor is not clear.

After initially investigating the charge transport properties of functionalized CNT/organic hole transported composites, the inventors have surprisingly found that highly effective charge transport components may be produced by embedding carbon nanotubes functionalized (wrapped) with a semiconducting polymer in an electrically insulating matrix. Functionalisation of the CNTs with a semiconducting polymer and replacement of known organic hole transporters with an electrically insulating matrix unexpectedly leads to charge transport components with excellent properties. Photovoltaic devices with power conversion efficiencies in excess of 15% have been made using this new charge transport component.

It has also been found that perovskite films coated with the component for transporting charge as described herein show excellent and unexpected thermal and mechanical stability and resilience to water. Films of the invention are able to maintain perovskite structure after heating for prolonged time in air.

It has also been found that semiconductor devices according to the invention comprising the component for transporting charge as described herein show excellent and unexpected thermal and mechanical stability. Devices of the invention are able to maintain good device characteristics even after exposure to heat for prolonged periods of time.

Thus, the invention provides a semiconductor device comprising a component for transporting charge, which component comprises an electrically insulating matrix and, disposed in said matrix, carbon nanotubes functionalized with a semiconducting polymer.

Thus, as described above, the carbon nanotubes functionalized with a semiconducting polymer provide excellent charge transport properties while the electrically insulating matrix reduces short circuit currents and provides mechanical and thermal stability to the device.

The invention also provides a process for producing a semiconductor device, which photovoltaic device comprises a component for transporting charge, which component comprises an electrically insulating matrix and, disposed in said matrix, carbon nanotubes functionalized with a semiconducting polymer, which process comprises:
(a) providing a substrate and, disposed on a surface of the substrate, carbon nanotubes functionalized with a semiconducting polymer; and
(b) disposing an electrically insulating matrix onto the carbon nanotubes functionalized with a semiconducting polymer.

The invention further provides a semiconductor device obtainable by a process for producing a semiconductor device according to the invention.

The semiconductor device is typically an optoelectronic device, for instance a photovoltaic device.

### BRIEF DESCRIPTION OF THE FIGURES

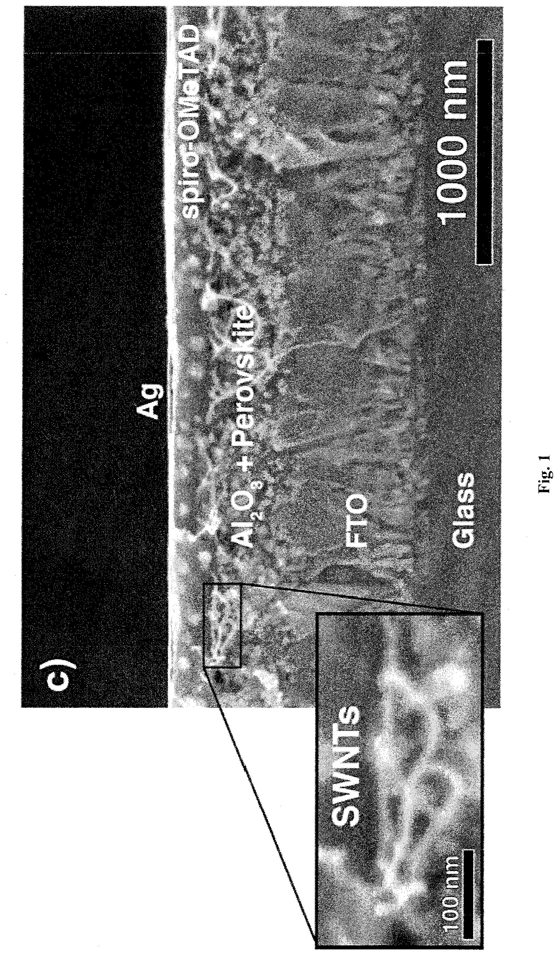

Figure 1 shows a cross-sectional scanning electron microscope (SEM) image of a device with a charge transporting component comprising functionalized SWNTs and sprio-OMeTAD.

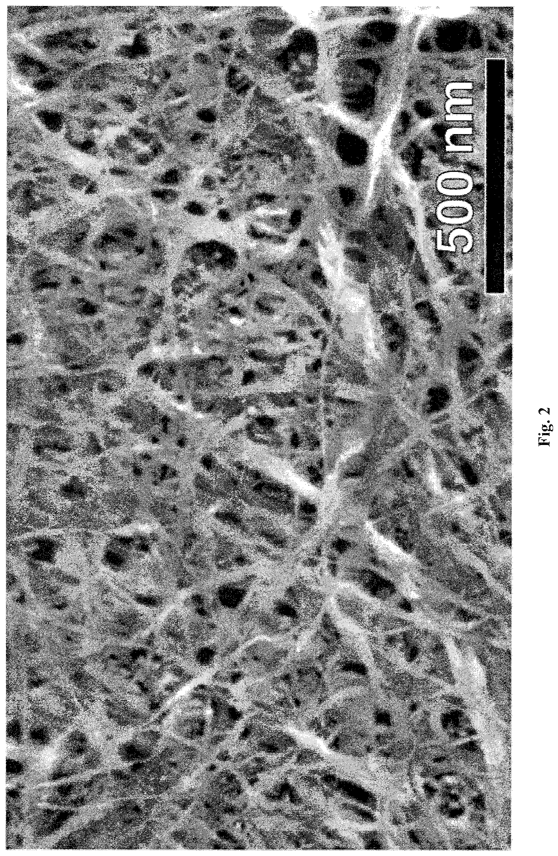

Figure 2 shows a top view (SEM) of a bare SWNT layer showing the thick mesh-like structure of the SWNT layer.

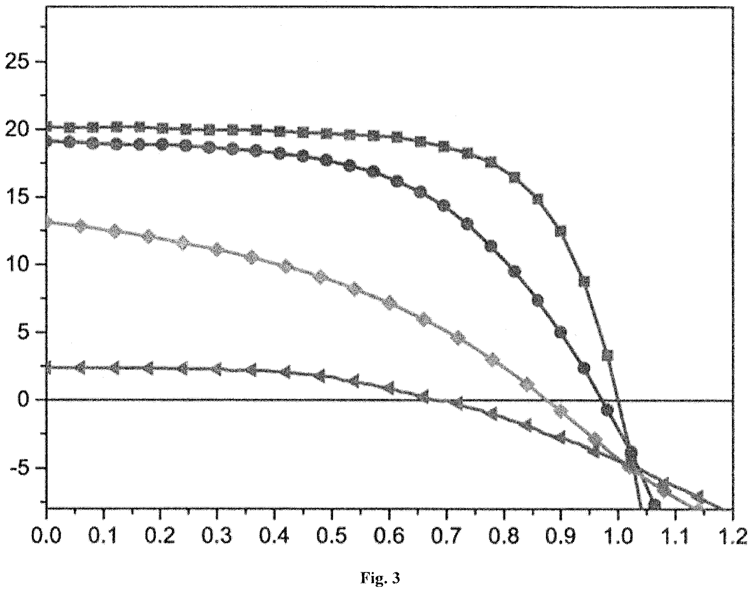

Figure 3 shows the comparison of current-voltage characteristics of two strategies of SWNT incorporation into spiro-OMeTAD and two control structures. The vertical axis shows current density (mA/cm²); the horizontal axis shows voltage (V); squares (■) represent SWNT-spiro-OMeTAD (stratified); circles (●) represent SWNT-spiro-OMeTAD (blend); diamonds (◆) represent spiro-OMeTAD (undoped); and leftwards-pointing triangles (◄) represent no HTL.

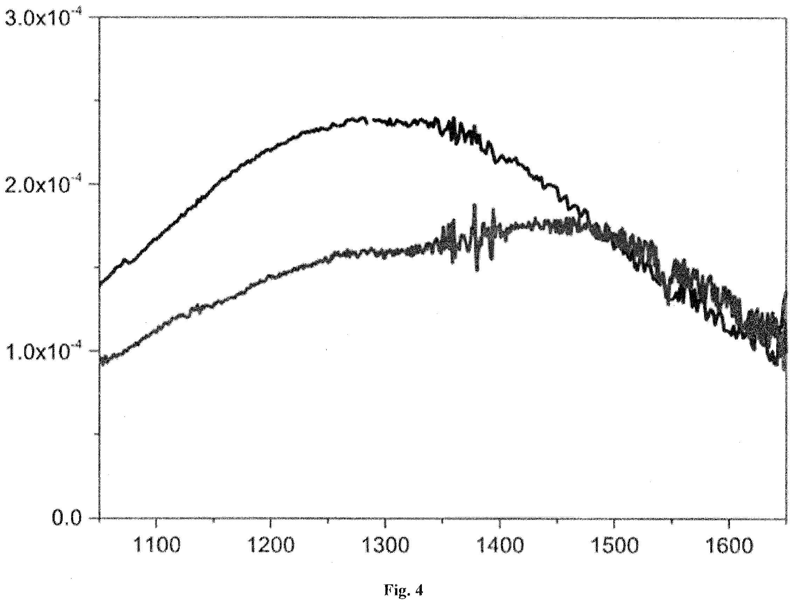

Figure 4 shows the photoinduced absorption spectrum of both neat spiro-OMeTAD and the SWNT-spiro-OMeTAD stratified HTL. The vertical axis represents -ΔT/T; the horizontal axis represents wavelength (nm); the upper curve represents spiro-OMeTAD; and the lower curve represents SWNT-spiro-OMeTAD (stratified).

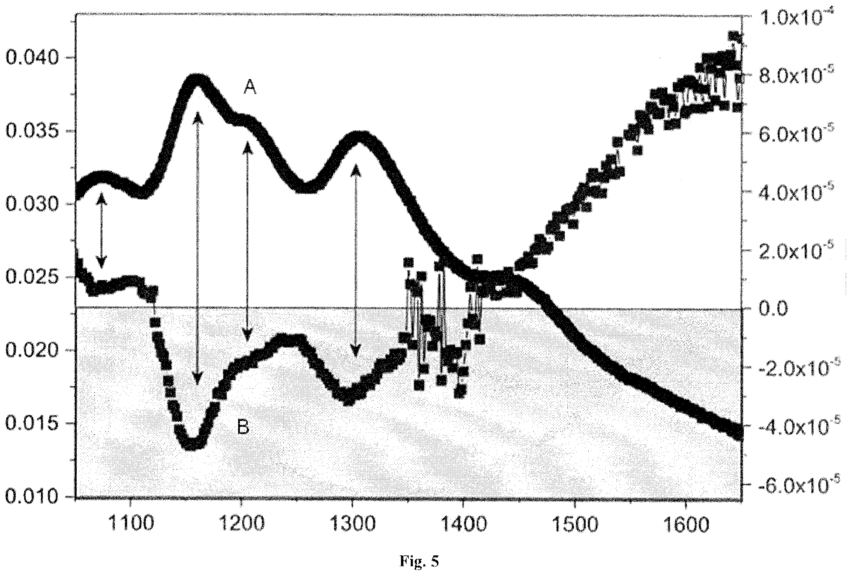

Figure 5 shows the PIA spectrum of a device with a neat P3HT-wrapped SWNT layer as HTL plotted together with the absorption spectrum of a SWNT film on glass. The left-hand vertical axis represents absorbance (a.u.) relating to curve A; the right-hand vertical axis represents -ΔT/T relating to curve B; the horizontal axis represents wavelength (nm); curve A represents the UV-Vis spectrum of SWNT film on glass; and curve B represents the PIA spectrum of a device with a neat P3HT-wrapped SWNT layer.

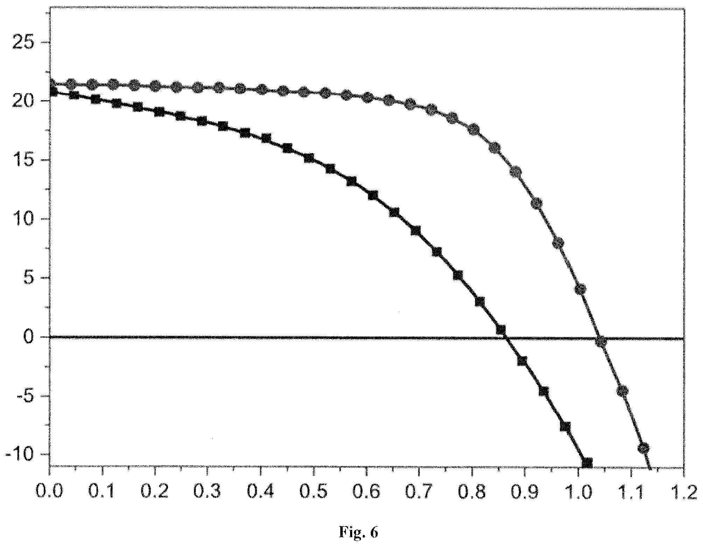

Figure 6 shows a plot of the current-voltage characteristics of a device with a HTL made of SWNTs only and of a device with the stratified SWNT-PMMA structure. The vertical axis shows current density (mA/cm²); the horizontal axis shows voltage (V); circles (●, upper curve) represent SWNTs-PMMA (stratified); and squares (■, lower curve) represent SWNTs.

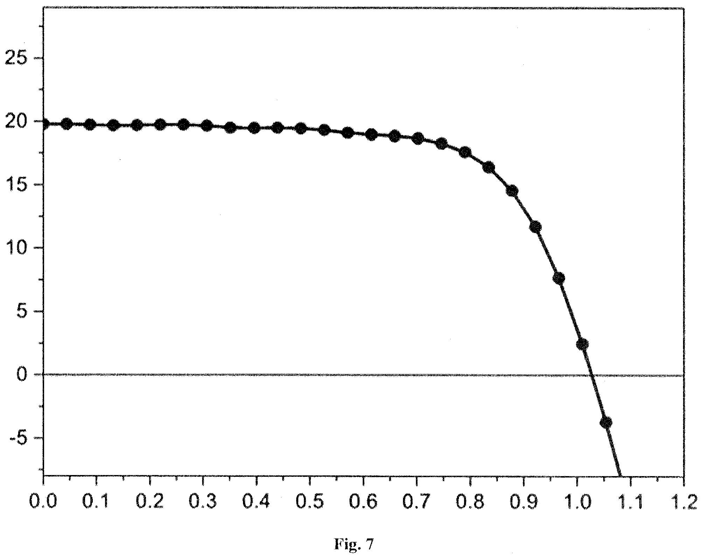

Figure 7 shows device characteristics for a solar cell with a hole transport layer comprising P3HT-functionalized SWNTs in a polycarbonate matrix, wherein the solar cell has been heated at 80°C for 96 hours. The vertical axis shows current density (mA/cm²); and the horizontal axis shows voltage (V).

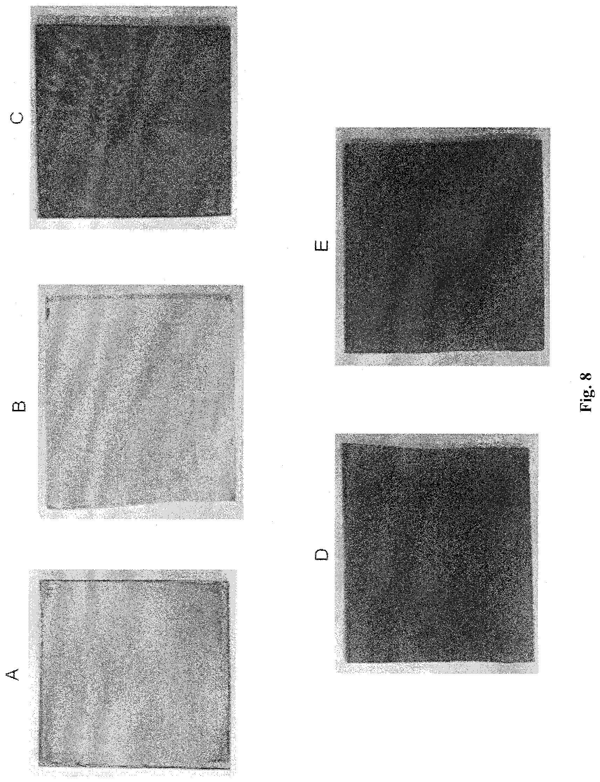

Figure 8 shows photographs of devices comprising hole transporter layers selected from spiro-OMeTAD (A), poly(triarylamine) (B), poly(3-hexylthiophene) (C), functionalized SWNTs with a polycarbonate matrix (D), and functionalized SWNTs with a poly(methyl methacrylate) matrix (E).

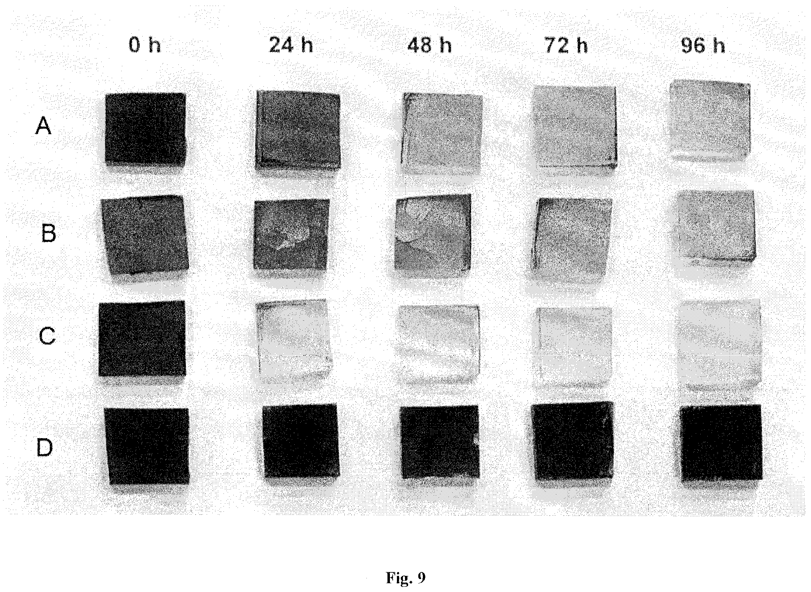

Figure 9 shows photographs of devices comprising hole transporter layers selected from Li-spiro-OMeTAD (A), poly(3-hexylthiophene) (B), poly(triarylamine) (C) and functionalized SWNTs with a poly(methyl methacrylate) matrix (D). The devices had been exposed to 80°C in moist air for different lengths of time ranging from 0 to 96 h.

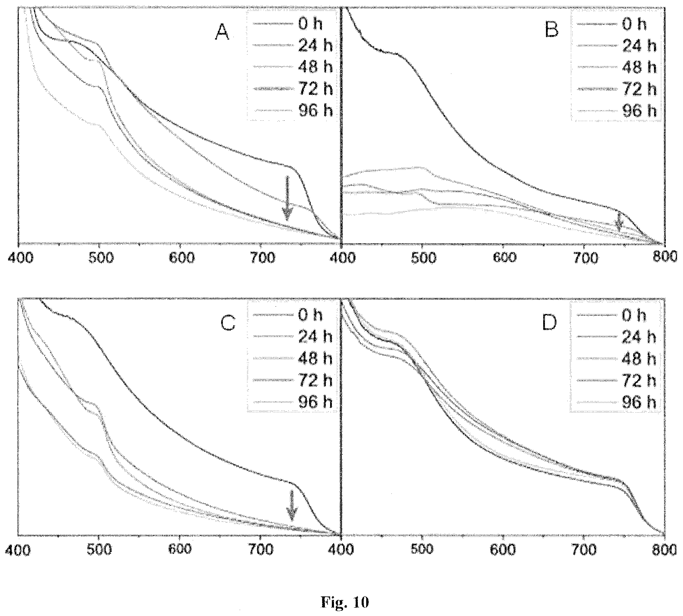

Figure 10 shows the absorption spectra of devices comprising hole transporter layers selected from spiro-OMeTAD (A), poly(3-hexylthiophene) (B), poly(triarylamine) (C) and functionalized SWNTs with a poly(methyl methacrylate) matrix (D). The spectra show the change in absorption in 24 h intervals due to heating of the devices at 80°C. The horizontal axis is wavelength (nm).

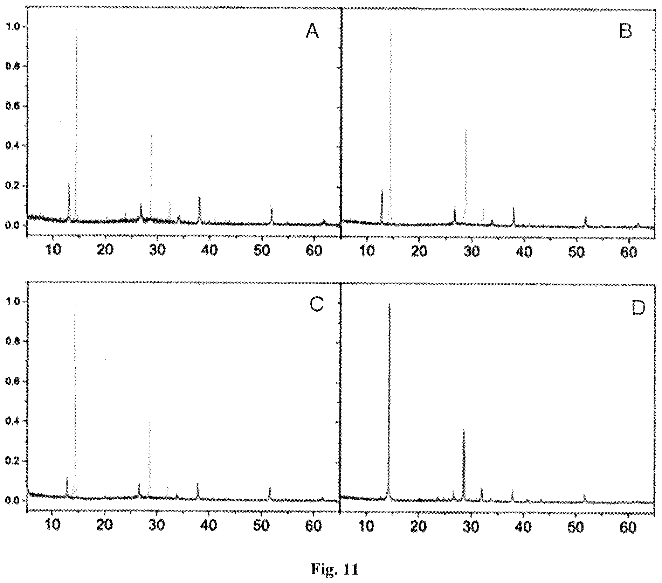

Figure 11 shows the X-ray diffraction spectra of devices comprising hole transporter layers selected from spiro-OMeTAD (A), poly(3-hexylthiophene) (B), poly(triarylamine) (C) and functionalized SWNTs with a poly(methyl methacrylate) matrix (D) before (dotted line) and after (solid line) 96 h of heat exposure at 80°C in moist air.

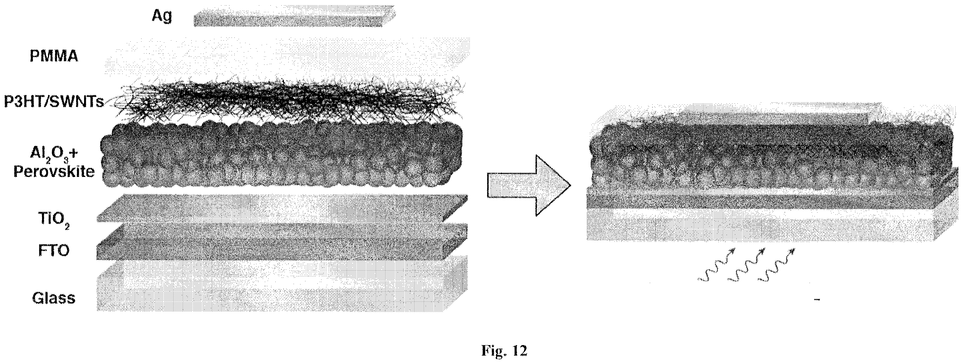

Figure 12 shows an example of the schematic architecture of a perovskite solar cell with a hole-transporting structure comprised of functionalized SWNTs with a poly(methyl methacrylate) matrix.

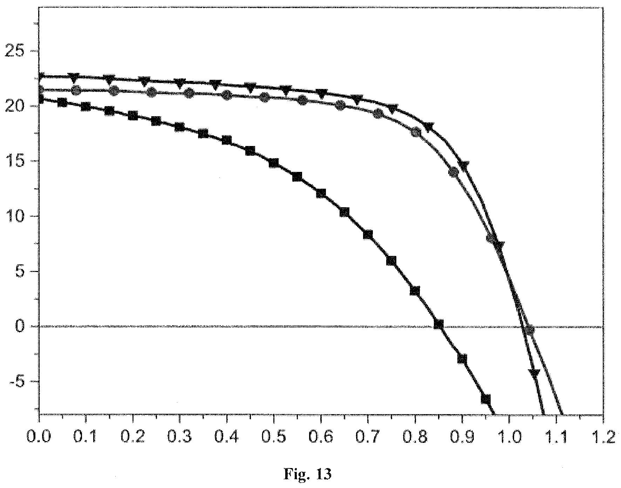

Figure 13 shows the current-voltage characteristics of three different perovskite solar cells comprising hole transporter layers based on functionalized SWNTs with and without poly(methyl methacrylate) matrix. The vertical axis shows current density (mA/cm²); the horizontal axis shows voltage (V); downwards-pointing triangles (▼) represent P3HT/SWNT (CG200)-PMMA; circles (●) represent P3HT/SWNT(HiPCO)-PMMA; and squares (■, lower curve) represent P3HT/SWNT(HiPCO).

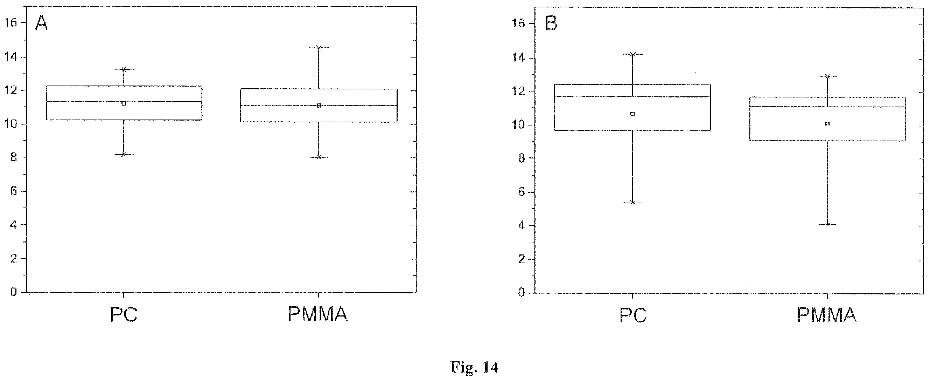

Figure 14 shows the distribution of power-conversion efficiency values of devices comprising hole transporter layers of functionalized SWNTs and either a polycarbonate (PC) or a poly(methyl methacrylate) (PMMA) matrix, before (A) and after (B) being exposed to 80°C for 96 hours in moist air.

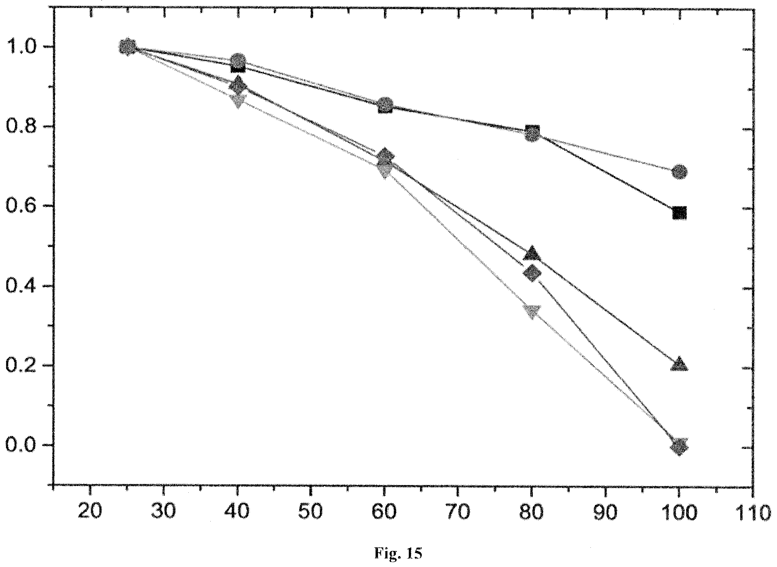

Figure 15 shows the characteristic behavior of the power-conversion efficiency at increased temperature ranging from 25°C to 100°C for devices comprising different hole transporter layers. The vertical axis shows normalized power conversion efficiency (%); the horizontal axis shows temperature (°C); upwards-pointing triangles (▲) represent Li-TFSI doped spiro-OMeTAD; diamonds (◆) represent poly(triarylamine); downwards-pointing triangles (▼) represent poly(3-hexylthiophene); squares (■) represent P3HT functionalized SWNTs with a poly(methyl methacrylate) matrix; and circles (●) represent P3HT functionalized SWNTs with a polycarbonate matrix.

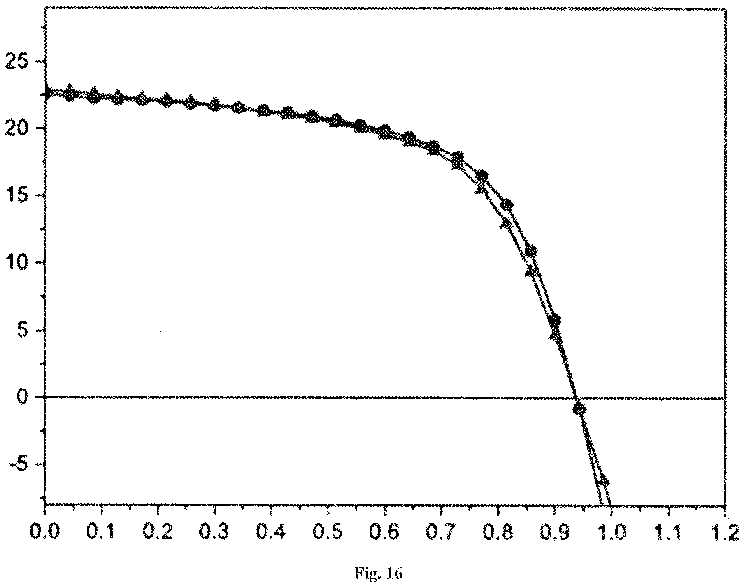

Figure 16 shows the current-voltage characteristics of a device comprising a hole transporter layer of functionalized SWNTs and a polycarbonate matrix before (circles,●) and after (upwards-pointing triangles, ▲) being exposed to a stream of running water for 60 seconds.

### DETAILED DESCRIPTION OF THE INVENTION

### Definitions

The term "semiconductor device", as used herein, refers to a device comprising a functional component which comprises a semiconductor material. This term may be understood to be synonymous with the term "semiconducting device". Examples of semiconductor devices include a photovoltaic device, a solar cell, a photo detector, a photodiode, a photosensor, a chromogenic device, a transistor, a light-sensitive transistor, a phototransistor, a solid state triode, a battery, a battery electrode, a capacitor, a super-capacitor, a light-emitting device, or a light-emitting diode. The term "optoelectronic device", as used herein, refers to devices which source, control or detect light. Light is understood to include any electromagnetic radiation. Examples of optoelectronic devices include photovoltaic devices, photodiodes (including solar cells), phototransistors, photomultipliers, photoresistors, and light emitting diodes.

The term "matrix", as used herein, refers to a material or structure in which another material is embedded. A matrix is typically a continuous material or structure. The material embedded in the matrix is typically in the form of a plurality of discrete volumes. The material embedded in the matrix is typically dispersed within the matrix. The matrix employed in the present invention is of course the electrically insulating matrix. The other material which is embedded in (and typically dispersed within) the matrix employed in the present invention is of course the carbon nanotubes that are functionalized with a semiconducting polymer.

The term "dispersed", as used herein, takes its normal meaning, i.e. "distributed over a volume". Accordingly, a material which is dispersed within a matrix is distributed within a matrix, over a volume of the matrix.

The term "carbon nanotube" is well known in the art. Carbon nanotubes (CNTs) are an allotrope of carbon with a cylindrical nanostructure. The term "carbon nanotubes functionalized with a semiconducting polymer" refers to carbon nanotubes which have been treated with a semiconducting polymer. Typically carbon nanotubes functionalized with a semiconducting polymer will have one or more molecules of the semiconducting polymer in contact with the carbon nanotubes. Functionalisation typically changes the charge transport and/or the dispersion properties of the CNTs.

The term "semiconducting", as used herein, refers to a material having a refers to a material with electrical conductivity intermediate in magnitude between that of a conductor and a dielectric. A semiconducting material may be an n-type semiconductor, a p-type semiconductor or an intrinsic semiconductor.

The term "n-type region", as used herein, refers to a region of one or more electron-transporting (i.e. n-type) materials. Similarly, the term "n-type layer" refers to a layer of an electron-transporting (i.e. an n-type) material. An electron-transporting (i.e. an n-type) material could be a single electron-transporting compound or elemental material, or a mixture of two or more electron-transporting compounds or elemental materials. An electron-transporting compound or elemental material may be undoped or doped with one or more dopant elements.

The term "p-type region", as used herein, refers to a region of one or more hole-transporting (i.e. p-type) materials. Similarly, the term "p-type layer" refers to a layer of a hole-transporting (i.e. a p-type) material. A hole-transporting (i.e. a p-type) material could be a single hole-transporting compound or elemental material, or a mixture of two or more hole-transporting compounds or elemental materials. A hole-transporting compound or elemental material may be undoped or doped with one or more dopant elements.

The term "polymer", as used herein, refers to a material comprising molecules formed of repeating units. Polymer molecules typically comprise greater than or equal to 10 repeating units, for instance greater than or equal to 15 repeating units. The term "oligomer", as used herein, refers to a material comprising molecules formed of from 3 to 9 repeating units.

The term "metallic", as used herein, refers to a material with a high electrical conductivity, for instance an electrical conductivity of greater than 10³ Sm⁻¹. Materials such as nanotubes may be metallic in only some directions, for instance along their length.

The term "photoactive material", as used herein, refers to a material which either (i) absorbs light, which may then generate free charge carriers; or (ii) accepts charge, both electrons and holes, which may subsequently recombine and emit light.

The term "perovskite", as used herein, refers to a material with a three-dimensional crystal structure related to that of CaTiO₃ or a material comprising a layer of material, which layer has a structure related to that of CaTiO₃. The structure of CaTiO₃ can be represented by the formula ABX₃, wherein A and B are cations of different sizes and X is an anion. In the unit cell, the A cations are at (0,0,0), the B cations are at (1/2, 1/2, 1/2) and the X anions are at (1/2, 1/2, 0). The A cation is usually larger than the B cation. The skilled person will appreciate that when A, B and X are varied, the different ion sizes may cause the structure of the perovskite material to distort away from the structure adopted by CaTiO₃ to a lower-symmetry distorted structure. The symmetry will also be lower if the material comprises a layer that has a structure related to that of CaTiO₃. Materials comprising a layer of perovskite material are well known. For instance, the structure of materials adopting the K₂NiF₄-type structure comprises a layer of perovskite material. The skilled person will appreciate that a perovskite material can be represented by the formula [A][B][X]₃, wherein [A] is at least one cation, [B] is at least one cation and [X] is at least one anion. When the perovskite comprise more than one A cation, the different A cations may distributed over the A sites in an ordered or disordered way. When the perovskite comprises more than one B cation, the different B cations may distributed over the B sites in an ordered or disordered way. When the perovskite comprise more than one X anion, the different X anions may distributed over the X sites in an ordered or disordered way. The symmetry of a perovskite comprising more than one A cation, more than one B cation or more than one X cation, will be lower than that of CaTiO₃.

The term "alkyl", as used herein, as used herein, refers to a linear or branched chain saturated hydrocarbon radical. An alkyl group may be a C₁₋₁₈ alkyl group, a C₁₋₁₄ alkyl group, a C₁₋₁₀ alkyl group, a C₁₋₆ alkyl group or a C₁₋₄ alkyl group. Examples of a C₁₋₁₀ alkyl group are methyl, ethyl, propyl, butyl, pentyl, hexyl, heptyl, octyl, nonyl or decyl. Examples of C₁₋₆ alkyl groups are methyl, ethyl, propyl, butyl, pentyl or hexyl. Examples of C₁₋₄ alkyl groups are methyl, ethyl, i-propyl, n-propyl, t-butyl, s-butyl or n-butyl. If the term "alkyl" is used without a prefix specifying the number of carbons anywhere herein, it has from 1 to 6 carbons (and this also applies to any other organic group referred to herein).

The term "aryl", as used herein, refers to a monocyclic, bicyclic or polycyclic aromatic ring which contains from 6 to 14 carbon atoms, typically from 6 to 10 carbon atoms, in the ring portion. Examples include phenyl, naphthyl, indenyl and indanyl groups. The term "aryl group", as used herein, includes heteroaryl groups. The term "heteroaryl", as used herein, refers to monocyclic or bicyclic heteroaromatic rings which typically contains from six to ten atoms in the ring portion including one or more heteroatoms. A heteroaryl group is generally a 5- or 6-membered ring, containing at least one heteroatom selected from O, S, N, P, Se and Si. It may contain, for example, one, two or three heteroatoms. Examples of heteroaryl groups include pyridyl, pyrazinyl, pyrimidinyl, pyridazinyl, furanyl, thienyl, pyrazolidinyl, pyrrolyl, oxazolyl, oxadiazolyl, isoxazolyl, thiadiazolyl, thiazolyl, isothiazolyl, imidazolyl, pyrazolyl, quinolyl and isoquinolyl.

The term "substituted", as used herein in the context of substituted organic groups and polymers, refers to an organic group or polymer which bears one or more substituents selected from C₁₋₁₀ alkyl, aryl (as defined herein), cyano, amino, nitro, C₁₋₁₀ alkylamino, di(C₁₋₁₀)alkylamino, arylamino, diarylamino, aryl(C₁₋₁₀)alkylamino, amido, acylamido, hydroxy, oxo, halo, carboxy, ester, acyl, acyloxy, C₁₋₁₀ alkoxy, aryloxy, halo(C₁₋₁₀)alkyl, sulfonic acid, thiol, C₁₋₁₀ alkylthio, arylthio, sulfonyl, phosphoric acid, phosphate ester, phosphonic acid and phosphonate ester. Examples of substituted alkyl groups include haloalkyl, perhaloalkyl, hydroxyalkyl, aminoalkyl, alkoxyalkyl and alkaryl groups. When a group is substituted, it may bear 1, 2 or 3 substituents. For instance, a substituted group may have 1 or 2 substitutents. When a polymer is substituted, it may bear 1, 2 or 3 substituents per repeating unit (monomer) in that polymer. For instance, a substituted polymer may have 1 or 2 substituents per repeating unit.

The term "porous", as used herein, refers to a material within which pores are arranged. Thus, for instance, in a porous scaffold material the pores are volumes within the scaffold where there is no scaffold material. The individual pores may be the same size or different sizes. The size of the pores is defined as the "pore size". The limiting size of a pore, for most phenomena in which porous solids are involved, is that of its smallest dimension which, in the absence of any further precision, is referred to as the width of the pore (i.e. the width of a slit-shaped pore, the diameter of a cylindrical or spherical pore, etc.). To avoid a misleading change in scale when comparing cylindrical and slit-shaped pores, one should use the diameter of a cylindrical pore (rather than its radius) as its "pore-width" (J. Rouquerol et al., "Recommendations for the Characterization of Porous Solids", Pure & Appl. Chem., Vol. 66, No. 8, pp. 1739-1758, 1994). The following distinctions and definitions were adopted in previous IUPAC documents (K.S.W. Sing, et al, Pure and Appl. Chem., vol.57, n04, pp 603-919, 1985; and IUPAC "Manual on Catalyst Characterization", J. Haber, Pure and Appl. Chem., vol.63, pp. 1227-1246, 1991): micropores have widths (i.e. pore sizes) smaller than 2 nm; Mesopores have widths (i.e. pore sizes) of from 2 nm to 50 nm; and Macropores have widths (i.e. pore sizes) of greater than 50 nm. In addition, nanopores may be considered to have widths (i.e. pore sizes) of less than 1 nm.

Pores in a material may include "closed" pores as well as open pores. A closed pore is a pore in a material which is a non-connected cavity, i.e. a pore which is isolated within the material and not connected to any other pore and which cannot therefore be accessed by a fluid (e.g. a liquid, such as a solution) to which the material is exposed. An "open pore" on the other hand, would be accessible by such a fluid. The concepts of open and closed porosity are discussed in detail in J. Rouquerol et al., "Recommendations for the Characterization of Porous Solids", Pure & Appl. Chem., Vol. 66, No. 8, pp. 1739-1758, 1994.

Open porosity, therefore, refers to the fraction of the total volume of the porous material in which fluid flow could effectively take place. It therefore excludes closed pores. The term "open porosity" is interchangeable with the terms "connected porosity" and "effective porosity", and in the art is commonly reduced simply to "porosity". (The perovskite semiconductor present in the "layer of a perovskite semiconductor without open porosity", in the optoelectronic device of the invention, cannot therefore be said to be a "porous perovskite" .)

The term "without open porosity", as used herein, therefore refers to a material with no effective open porosity. Thus, a material without open porosity typically has no macropores and no mesopores. A material without open porosity may comprise micropores, however. Such micropores are typically too small to have a negative effect on a material for which low porosity is desired.

The term "compact layer", as used herein, refers to a layer without mesoporosity or macroporosity. A compact layer may have microporosity or nanoporosity.

### Semiconductor device

The invention provides a semiconductor device comprising a component for transporting charge, which component comprises an electrically insulating matrix and, disposed in said matrix, carbon nanotubes functionalized with a semiconducting polymer. The semiconductor device is typically an optoelectronic device, for instance a photovoltaic device.

### Electrically insulating matrix

The electrically insulating matrix typically comprises an electrically insulating organic material, or a dielectric inorganic material. The electrically insulating organic material or the dielectric inorganic material typically has an electrical conductivity of less than or equal to 10⁻² Sm⁻¹, for instance less than or equal to 10⁻⁴ Sm⁻¹. The electrically insulating organic material may be a polymeric material, an oligomeric material or a small organic molecule material.

The electrically insulating matrix typically comprises an electrically insulating organic polymer. An electrically insulating organic polymer used in the electrically insulating matrix may be any suitable electrically insulating organic polymer. The electrically insulating organic polymer typically has an electrical conductivity of less than or equal to 10⁻⁴ Sm⁻¹, for instance less than or equal to 10⁻⁶ Sm⁻¹. The electrically insulating organic polymer may have an electrical conductivity of less than or equal to 10⁻⁸ Sm⁻¹.

The electrically insulating organic polymer is typically a polymer where there is no π-conjugation between adjacent repeating units in the polymer. Examples of electrically insulating polymers include a poly(alkene), a poly(acrylate), a poly(methacrylate), poly(alkylacrylate), a poly(amide), a poly(ester), a poly(vinyl alcohol), a poly(styrene), a poly(butyrate), a poly(imide) or a poly(carbonate). Typically, the electrically insulating organic polymer comprises a poly(acrylate), a poly(methacrylate), a poly(vinyl alcohol), a poly(styrene), a poly(butyrate), a poly(imide) or a poly(carbonate).

Examples of a poly(alkene) include polyethylene, polypropylene, polybut-1-ene and polymethylpentene. Examples of a poly(acrylate) include poly(methyl acrylate), poly(ethyl acrylate), poly(propyl acrylate) and poly(butyl acrylate). Examples of a poly(methacrylate) include poly(methyl methacrylate) and poly(ethyl methacrylate). Examples of a poly(alkacrylate) include poly(methyl methacrylate), poly(methyl ethacrylate), poly(ethyl methacrylate) and poly(ethyl ethacrylate). Examples of a poly(amide) include polyamide 6, polyamide 6-6, polyamide 12 and polyamide 12-12. Examples of a poly(ester) include polyethylene terephthalate, polybutylene terephthalate, polyethylene naphthalate, polyethylene apidate, polyethylene succinate and polycaprolactone. Examples of a poly(vinyl alcohol) include poly(ethenol) and poly(vinylacetate). Examples of a poly(styrene) include unsubstituted polystyrene and poly(vinyltoluene). Examples of a poly(butyrate) include polybutyrate apidate terephthalate and polybutyrate succinate terephthalate. An example of a poly(imide) is poly(oxydiphenylene pyromellitimide). Examples of a poly(carbonate) include polypropylene carbonate, poly(allyl diglycol carbonate) and poly(bisphenol A carbonate). Preferably the electrically insulating polymer is a poly(acrylate), a poly(methacrylate) or a poly(carbonate). For instance, the electrically insulating organic polymer comprises poly(methyl methacrylate).

### Functionalized carbon nanotubes

Carbon nanotubes functionalized with a semiconducting polymer are disposed in the electrically insulating matrix. The functionalized carbon nanotubes typically act as the material which transports charge in the component for transporting charge in the semiconductor device of the invention. Thus, the carbon nanotubes functionalized with a semiconducting polymer are typically conducting or semiconducting.

The carbon nanotubes functionalized with a semiconducting polymer may be dispersed within the electrically insulating matrix.

The carbon nanotubes functionalized with a semiconducting polymer may be randomly dispersed within electrically insulating matrix. In particular, the functionalized carbon nanotubes may be randomly dispersed within a region of the electrically insulating matrix, or they may be randomly dispersed throughout the whole of the electrically insulating matrix. When the functionalized carbon nanotubes are randomly dispersed within a region of the electrically insulating matrix, they may for example be randomly dispersed within a sub-layer of said electrically insulating matrix, for instance a first sub-layer or a second sub-layer as defined herein.

The carbon nanotubes functionalized with a semiconducting polymer may be randomly distributed within a volume of the electrically insulating matrix. The volume of the electrically insulating matrix within which the functionalized carbon nanotubes are randomly distributed may for example be a particular region of the electrically insulating matrix, for instance a sub-layer of said electrically insulating matrix. The sub-layer may be a first sub-layer or a second sub-layer as defined herein.

The carbon nanotubes functionalized with a semiconducting polymer may be functionalized with the semiconducting polymer by any means. Typically the carbon nanotubes functionalized with a semiconducting polymer are obtainable by a functionalisation process comprising treating carbon nanotubes with a semiconducting polymer. The functionalisation process may comprise treating carbon nanotubes with a solution of a semiconducting polymer. The functionalisation process may further comprise centrifuging the solution comprising the carbon nanotubes functionalized with a semiconducting polymer to remove non-functionalized nanotubes and other carbonaceous aggregates. For example, the carbon nanotubes functionalized with a semiconducting polymer may be obtainable by a functionalisation process comprising (i) adding carbon nanotubes (for instance single walled carbon nanotubes) to a composition comprising a solvent (such as a polar aprotic solvent, for instance chlorobenzene) and a semiconducting polymer (such as those described herein, for instance a poly(alkylthiophene)); and (ii) optionally centrifuging the resulting mixture. The functionalized carbon nanotubes may then be removed by heating the resulting mixture mildly (for instance at a temperature of from 40 to 100°C) for from 10 to 100 minutes to cause aggregation of the carbon nanotubes functionalized with a semiconducting polymer. These aggregates may then be removed by centrifuging the mixture comprising the aggregates.

The semiconductor polymer functionalizes the CNTs by interacting with them. Thus, the semiconducting polymer is typically in contact with the CNTs. Each CNT may be functionalized by one or more molecules of the semiconducting polymer. Typically, when a CNT is functionalized with a semiconducting polymer, the polymer and the CNT interact in such as way that the polymer remains associated with the CNT in solution.

Typically, carbon nanotubes are coated at least in part with the semiconducting polymer. For instance, the carbon nanotubes may be wrapped in the semiconducting polymer. The carbon nanotubes may be wrapped in the semiconducting polymer in a regular way, for instance by a helical arrangement of one or more molecules of the semiconducting polymer around one or more carbon nanotubes.

The semiconducting polymer is typically a conjugated polymer. Conjugated polymers comprise repeating units comprising arylene, heteroarylene, alkenylene (e.g. C₁₋₂₀ alkenylene) or alkynylene (e.g. C₁₋₂₀ alkynylene) units. Examples of conjugated polymers include polyacetylenes, polyphenylenes, polyparaphenylenes, polyparaphenylene vinylenes, polyparaphenylene acetylenes, polyazulenes, polynaphthalenes, polypyrenes, polyanilines, polyparaphenylene sulphides, polyfluorenes, polypyrroles, polythiophenes, polythieno[3,2-b]thiophenes, polycarbazoles, polyazepines and polyindoles or a mixture thereof, each of which may be substituted or unsubstituted. Mixtures of these polymers also cover copolymers comprising repeating units selected from two or more of these polymers. Such a polymer could comprise alternating repeating units of phenylene and thiophene, for example. The polymers may be substituted or unsubstituted.

Preferably, the semiconducting polymer is a hole-transporting polymer. Hole transporting polymers typically form p-type semiconducting materials.

The semiconducting polymer is typically a substituted or unsubstituted polythiophene, a substituted or unsubstituted polyfluorene, or a substituted or unsubstituted poly(phenylene vinylene). Examples of a substituted or unsubstituted polythiophene include poly(3-alkylthiophene) and poly(3,4-ethylenedioxythiophene). Examples of a substituted or unsubstituted polyfluorene include poly(9,9-dialkylfluorenyl), poly(9,9-dialkylfluorene-alt-benzothiadiazole) or poly(indenofluorene). Examples of a substituted or unsubstituted poly(phenylene vinylene) include poly(alkylphenylene vinylene) and unsubstituted poly(phenylene vinylene).

Preferably, the semiconducting polymer is selected from poly(3-hexylthiophene), poly(3-octylthiophene), poly(3-dodecylthiophene), poly(9,9-dioctofluorene), poly(9,9-di-n-octylfluorene-alt-benzothiadiazole), poly(indenofluorene) and poly(phenylene vinylene).

More preferably, the semiconducting polymer is poly(3-hexylthiophene). Poly(3-alkylthiophene) may be regioregular or regioirregular. If the semiconducting polymer used in the invention is a poly(alkylthiophene), it is preferably regioregular. For instance, the poly(alkylthiophene) may be greater than or equal to 90% regioregular.

Any suitable carbon nanotubes may be used in the semiconductor device of the invention. Carbon nanotubes may be classified in a number of ways, for instance by their structure or electronic properties.

The carbon nanotubes may be single-walled or multi-walled carbon nanotubes. Preferably, the carbon nanotubes are single-walled carbon nanotubes (SWNTs). The carbon nanotubes may be high-pressure carbon monoxide (HiPCO) CNTs, for instance HiPCO SWNTs. The CNTs may have an average diameter of from 0.5 to 2 nm. Preferably the CNTs have an average diameter of from 0.7 to 1.4 nm, for instance from 0.8 to 1.2 nm.

The carbon nanotubes may be CoMoCAT® CNTs, for instance CoMoCAT CG200 SWNTs, SG 65i or SG 76. The CNTs may have an average diameter of from 0.5 to 2 nm. Preferably the CNTs have an average diameter of from 0.7 to 1.4 nm.

Typically, the carbon nanotubes are semiconducting carbon nanotubes, metallic carbon nanotubes, or a mixture of semiconducting carbon nanotubes and metallic carbon nanotubes. The carbon nanotubes may be a mixture of semiconducting carbon nanotubes and metallic carbon nanotubes. The ratio may for instance be 2:1 semiconducting to metallic CNTs. Preferably, the CNTs have a ratio of 3:2 semiconducting to metallic CNTs.

### Component for transporting charge

The component for transporting charge may be an electron-transporting component or a hole-transporting component. Typically, the component for transporting charge is a hole-transporting component.

The component for transporting charge may be in any suitable form. Typically the component for transporting charge is in the form of a layer. Thus, typically the component for transporting charge is a charge-transporting layer.

The area density of the CNTs functionalized with a semiconducting polymer may be varied to improve the device performance. The mass of said carbon nanotubes functionalized with a semiconducting polymer per unit area of the charge-transporting layer is typically at least 3 µg/cm². For instance, the mass of said carbon nanotubes functionalized with a semiconducting polymer per unit area of the charge-transporting layer may be at least 6 µg/cm². Preferably, the mass of said carbon nanotubes functionalized with a semiconducting polymer per unit area of the charge-transporting layer is from 3 µg/cm² to 20 µg/cm², optionally from 5 µg/cm² to 15 µg/cm².

As discussed herein, it is preferable that the functionalised CNTs are in contact with both components between which charge is transported, but the component for transporting charge preferably does not allow the components between which charge is transported to be in direct contact, as this can lead to short-circuiting. Thus it is can be preferable to have a first sub-layer within the charge transport layer which has a greater concentration of functionalized CNTs than a second sub-layer. The first sub-layer can allow good contact between the functionalized CNTs and a component from which charge will be transported, while the second layer can act to confer thermal stability on the device by sealing in the component from which charge is transported and also prevent short circuiting due to contact between the two components on either side of the charge transporting layer.

Thus, preferably the charge-transporting layer comprises a first sub-layer in contact with a second sub-layer, wherein both the first sub-layer and the second sub-layer comprise said electrically insulating matrix and, disposed in said electrically insulating matrix, said carbon nanotubes functionalized with a semiconducting polymer, wherein the concentration of the carbon nanotubes functionalized with a semiconducting polymer is greater in the first sub-layer than in the second sub-layer. For instance, the concentration in the first sub-layer may be 20% greater than in the second layer. The concentration may be measured as a mass density (for instance gcm⁻³).

Such a charge-transporting layer may be obtainable by a process comprising (a) providing a substrate and, disposed on a surface of the substrate, carbon nanotubes functionalized with a semiconducting polymer; and (b) disposing an electrically insulating matrix onto the carbon nanotubes functionalized with a semiconducting polymer. For instance, such a charge-transporting layer may be obtainable by a process comprising (a) disposing said carbon nanotubes functionalized with a semiconducting polymer on the surface of the substrate; and (b) disposing an electrically insulating matrix onto the carbon nanotubes functionalized with a semiconducting polymer.

The charge-transporting layer is preferably a p-type layer.

The semiconductor device according to the invention may comprise a photoactive region disposed between a first electrode and a second electrode, which photoactive region comprises said charge-transporting layer. If a photoactive region is present, the semiconductor device is typically an optoelectronic device.

The photoactive region preferably further comprises a photoactive material. Typically, the photoactive material is in contact with said charge-transporting layer.

### Photoactive material

In the semiconductor device of the invention, the photoactive material typically comprises a photoactive semiconductor or a photosensitising dye. The semiconductor device is typically an optoelectronic device, for instance a photovoltaic device.

Examples of a suitable photosensitising dye is the indolene dye D102, an organic "push-pull" dye such as those described in T. Horiuchi et al. ("High Efficiency of Dye-Sensitized Solar Cells Based on Metal-Free Indoline Dyes", J. Am. Chem. Soc. 126, 12218-12219 (2004)), a ruthenium complex dye, an organic dyes such as those described in W. Zeng, et al. ("Efficient Dye-Sensitized Solar Cells with an Organic Photosensitizer Featuring Orderly Conjugated Ethylenedioxythiophene and Dithienosilole Blocks", Chem. Mater. 22, 1915-1925 (2010)) or a rylene based dye such as those described in US 2012/0017995.

The photoactive material typically comprises a photoactive semiconductor selected from a perovskite, gallium arsenide, lead selenide, lead sulphide, indium arsenide, indium phosphide, copper indium selenide, copper zinc tin sulphide, copper zinc tin selenide, copper zinc tin selenide sulphide, copper indium gallium selenide, copper indium gallium diselenide, and copper indium gallium diselenide sulphide. For instance, the photoactive material may comprise a perovskite, copper indium gallium selenide, or copper indium gallium diselenide.

Preferably the photoactive material comprises a photoactive perovskite. The photoactive perovskite in the device of the invention typically comprises a metal halide perovskite. The formula of the metal halide perovskite comprises at least one metal and at least one halide. The perovskite comprises a first cation, a second cation and at least one halide anion, wherein at least one of the first and second cations comprises a metal cation. The perovskite may contain further cations and anions. The perovskite may be a layered perovskite. Examples of layered perovskites include those described in WO 2014/020499.

Metal halide perovskites are described in WO 2013/171517, WO 2013/171518, and WO 2013/171520. Any of the metal halide perovskites described in any of WO 2013/171517, WO 2013/171518, and WO 2013/171520 may be used in the present invention.

The first cation may be any cation, but is often a metal cation or an organic cation. If the first cation is a metal cation, it may be a monovalent or a divalent metal cation. The first cation may be selected from Li⁺, Na⁺, K⁺, Rb⁺, and Cs⁺. The first cation is typically an organic cation. If the first cation is an organic cation it may be any organic cation described below.

The second cation is typically a metal cation. The second cation may be any metal cation. The second cation may be a divalent metal cation. The second cation may be a divalent metal cation selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Sn²⁺, Yb²⁺ and Eu²⁺.

Usually the at least one halide anion is selected from fluoride, chloride, bromide and iodide, for instance chloride, bromide and iodide.

The photoactive perovskite may be an organometal halide perovskite. Thus, the photoactive perovskite is typically a perovskite of the formula (I):

[A][B][X]₃ (I)

wherein:
[A] is at least one organic cation;
[B] is at least one metal cation, wherein [B] comprises at least one of Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Sn²⁺, Yb²⁺ and Eu²⁺; and
[X] is at least one halide anion.

The photoactive perovskite thus typically comprises an organic cation, a metal cation and at least halide anion. The photoactive perovskite may be a perovskite of the formula [A][B][X]₃ wherein: [A] is at least one organic cation; [B] is at least one metal cation selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Sn²⁺, Yb²⁺ and Eu²⁺; and [X] is at least one halide anion.

[B] often comprises at least one of Sn²⁺, Pb²⁺, Cu²⁺, Ge²⁺ and Ni²⁺. The metal cation may be selected from Sn²⁺, Pb²⁺, Cu²⁺, Ge²⁺ and Ni²⁺. The metal cation may be selected from Sn²⁺ and Pb²⁺.

The photoactive material may comprise a mixed-halide perovskite of the formula (II)

[A][B][X]₃ (II)

wherein:
[A] is at least one organic cation of the formula (R₁R₂R₃R₄N)⁺, wherein: (i) R₁ is hydrogen, unsubstituted or substituted C₁-C₂₀ alkyl, or unsubstituted or substituted aryl; (ii) R₂ is hydrogen, unsubstituted or substituted C₁-C₂₀ alkyl, or unsubstituted or substituted aryl; (iii) R₃ is hydrogen, unsubstituted or substituted C₁-C₂₀ alkyl, or unsubstituted or substituted aryl; and (iv) R₄ is hydrogen, unsubstituted or substituted C₁-C₂₀ alkyl, or unsubstituted or substituted aryl; or
[A] is at least one organic cation of the formula (R₅R₆N=CH-NR₇R₈)⁺, wherein: (i) R₅ is hydrogen, unsubstituted or substituted C₁-C₂₀ alkyl, or unsubstituted or substituted aryl; (ii) R₆ is hydrogen, unsubstituted or substituted C₁-C₂₀ alkyl, or unsubstituted or substituted aryl; (iii) R₇ is hydrogen, unsubstituted or substituted C₁-C₂₀ alkyl, or unsubstituted or substituted aryl; and (iv) R₈ is hydrogen, unsubstituted or substituted C₁-C₂₀ alkyl, or unsubstituted or substituted aryl;
[B] is at least one divalent metal cation; and
[X] is two or more different halide anions.

The organic cation may be any organic cation, i.e. a cation which comprises at least one carbon atom and optionally at least one hydrogen atom. The organic cation often has the formula (R⁵R⁶R⁷R⁸N)⁺, wherein: R⁵ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; R⁶ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; R⁷ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; and R⁸ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl.

The organic cation may have the formula (R⁵R⁶R⁷R⁸N)⁺, wherein: R⁵ is a group selected from H, unsubstituted C₁₋₁₈-alkyl, and unsubstituted aryl; R⁶ is a group selected from H, unsubstituted C₁₋₁₈-alkyl, and unsubstituted aryl; R⁷ is a group selected from H, unsubstituted C₁₋₁₈-alkyl, and unsubstituted aryl; and R⁸ is a group selected from H, unsubstituted C₁₋₁₈-alkyl, and unsubstituted aryl.

For instance, the organic cation may have the formula (R⁹NH₃)⁺, wherein: R⁹ is hydrogen, or unsubstituted or substituted C₁₋₁₈-alkyl. For instance, R⁹ may be methyl or ethyl. Typically, R⁹ is methyl.

The organic cation may have the formula (R⁵R⁶N=CH-NR⁷R⁸)⁺, wherein: R⁵ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; R⁶ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; R⁷ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl; and R⁸ is a group selected from H, unsubstituted or substituted C₁₋₁₈-alkyl, unsubstituted or substituted C₃₋₁₀-cycloalkyl, unsubstituted or substituted C₂₋₁₈-alkenyl, unsubstituted or substituted C₂₋₁₈-alkynyl, and unsubstituted or substituted aryl.

The organic cation may have the formula (R⁵R⁶N=CH-NR⁷R⁸)⁺, wherein: R⁵ is a group selected from H, unsubstituted C₁₋₁₈-alkyl, and unsubstituted aryl; R⁶ is a group selected from H, unsubstituted C₁₋₁₈-alkyl, and unsubstituted aryl; R⁷ is a group selected from H, unsubstituted C₁₋₁₈-alkyl, and unsubstituted aryl; and R⁸ is a group selected from H, unsubstituted C₁₋₁₈-alkyl, and unsubstituted aryl.

Typically, R⁵ in the cation (R⁵R⁶N=CH-NR⁷R⁸)⁺ is hydrogen, methyl or ethyl, R⁶ is hydrogen, methyl or ethyl, R⁷ is hydrogen, methyl or ethyl, and R⁸ is hydrogen, methyl or ethyl. For instance R⁵ may be hydrogen or methyl, R⁶ may be hydrogen or methyl, R⁷ may be hydrogen or methyl, and R⁸ may be hydrogen or methyl. The organic cation may, for example, have the formula (H₂N=CH-NH₂)⁺.

The photoactive perovskite may comprise a mixed-halide perovskite, wherein the at least one halide anion may be two or more different halide anions. They may be two or three halide anions, or more typically, two different halide anions. Usually the halide anions are selected from fluoride, chloride, bromide and iodide, for instance chloride, bromide and iodide.

The perovskite of formula (I) may comprise one, two, three or four different metal cations, typically one or two different metal cations. Also, the perovskite of the formula (I), may, for instance, comprise one, two, three or four different organic cations, typically one or two different organic cations. Likewise, the perovskite of formula (I), may, comprise one two, three or four different anions, typically two or three different anions.

The organic and metal cations in the perovskite compound of formula (I) may be as further defined hereinbefore. Thus the organic cations may be selected from cations of formula (R⁵R⁶R⁷R⁸N)⁺, cations of formula (R⁹NH3)⁺, and cations of formula (R⁵R⁶N=CH-NR⁷R⁸)⁺ as defined above. The metal cations may be selected from divalent metal cations. For instance, the metal cations may be selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ and Eu²⁺. The metal cation may be selected from Sn²⁺, Pb²⁺, Cu²⁺, Ge²⁺ and Ni²⁺. The metal cation may be Sn²⁺ or Pb²⁺.

The photoactive perovskite may be a perovskite compound of the formula (IA):

AB[X]₃ (IA)

wherein: A is an organic cation; B is a metal cation; and [X] is two or more different halide anions. Preferably, [X] is two or three different halide anions. More preferably, [X] is two different halide anions. The organic cation and metal cation may be as defined above.

The photoactive perovskite may be a perovskite compound of formula (II):

ABX₃₋ₓX'ₓ (II)

wherein: A is an organic cation; B is a metal cation; X is a first halide anion; X' is a second halide anion which is different from the first halide anion; and x is from 0 to 3. Usually, x is from 0.05 to 0.95. For instance, x may be from 0.5 to 2.5, or from 0.75 to 2.25. Typically, x is from 1 to 2.

Again, in formula (II), the organic and metal cations may be as further defined hereinbefore. Thus the organic cations may be selected from cations of formula (R⁵R⁶R⁷R⁸N)⁺, cations of formula (R⁹NH3)⁺, and cations of formula (R⁵R⁶N=CH-NR⁷R⁸)⁺ as defined above. The metal cations may be selected from divalent metal cations. For instance, the metal cations may be selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ and Eu²⁺. The metal cation may be selected from Sn²⁺, Pb²⁺, Cu²⁺, Ge²⁺ and Ni²⁺. The metal cation may be Sn²⁺ or Pb²⁺.

The photoactive perovskite may be a perovskite compound selected from CH₃NH₃PbI₃, CH₃NH₃PbBr₃, CH₃NH₃PbCl₃, CH₃NH₃PbF₃, CH₃NH₃PbBrₓI₃₋ₓ, CH₃NH₃PbBrₓCl₃₋ₓ, CH₃NH₃PbIₓBr₃₋ₓ, CH₃NH₃PbIₓCl₃₋ₓ, CH₃NH₃PbClₓBr₃₋ₓ, CH₃NH₃PbI₃₋ₓClₓ, CH₃NH₃SnI₃, CH₃NH₃SnBr₃, CH₃NH₃SnCl₃, CH₃NH₃SnF₃, CH₃NH₃SnBrI₂, CH₃NH₃SnBrₓI₃₋ₓ, CH₃NH₃SnBrₓCl₃₋ₓ, CH₃NH₃SnF₃₋ₓBrₓ, CH₃NH₃SnIₓBr₃₋ₓ, CH₃NH₃SnIₓCl₃₋ₓ, CH₃NH₃SnF₃₋ₓIₓ, CH₃NH₃SnClₓBr₃₋ₓ, CH₃NH₃SnI₃₋ₓClₓ and CH₃NH₃SnF₃₋ₓClₓ, where x is from 0 to 3. x may be from 0.05 to 2.96. For instance, x may be from 0.1 to 2.9, or from 0.5 to 2.5. In some cases, x is from 0.75 to 2.25, or from 1 to 2.

The photoactive perovskite may be a perovskite compound selected from CH₃NH₃PbI₃, CH₃NH₃PbBr₃, CH₃NH₃PbCl₃, CH₃NH₃PbF₃, CH₃NH₃PbBrI₂, CH₃NH₃PbBrCl₂, CH₃NH₃PbIBr₂, CH₃NH₃PbICl₂, CH₃NH₃PbClBr₂, CH₃NH₃PbI₂Cl, CH₃NH₃SnI₃, CH₃NH₃SnBr₃, CH₃NH₃SnCl₃, CH₃NH₃SnF₃, CH₃NH₃SnBrI₂, CH₃NH₃SnBrCl₂, CH₃NH₃SnF₂Br, CH₃NH₃SnIBr₂, CH₃NH₃SnICl₂, CH₃NH₃SnF₂I, CH₃NH₃SnClBr₂, CH₃NH₃SnI₂Cl and CH₃NH₃SnF₂Cl.

The photoactive perovskite may be a perovskite compound selected from CH₃NH₃PbBrₓI₃₋ₓ, CH₃NH₃PbBrₓCl₃₋ₓ, CH₃NH₃PbIₓBr₃₋ₓ, CH₃NH₃PbIₓCl₃₋ₓ, CH₃NH₃PbClₓBr₃₋ₓ, CH₃NH₃PbI₃₋ₓClₓ, CH₃NH₃SnBrₓI₃₋ₓ, CH₃NH₃SnBrₓCl₃₋ₓ, CH₃NH₃SnF₃₋ₓBrₓ, CH₃NH₃SnIₓBr₃₋ₓ, CH₃NH₃SnIₓCl₃₋ₓ, CH₃NH₃SnF₃₋ₓIₓ, CH₃NH₃SnClₓBr₃₋ₓ, CH₃NH₃SnI₃₋ₓClₓ and CH₃NH₃SnF₃₋ₓClₓ, where x is from 0.05 to 2.95. For instance, x may be from 0.5 to 2.5, from 0.75 to 2.25, or from 1 to 2.

The photoactive perovskite may be selected from CH₃NH₃PbBrI₂, CH₃NH₃PbBrCl₂, CH₃NH₃PbIBr₂, CH₃NH₃PbICl₂, CH₃NH₃PbClBr₂, CH₃NH₃PbI₂Cl, CH₃NH₃SnBrI₂, CH₃NH₃SnBrCl₂, CH₃NH₃SnF₂Br, CH₃NH₃SnIBr₂, CH₃NH₃SnICl₂, CH₃NH₃SnF₂I, CH₃NH₃SnClBr₂, CH₃NH₃SnI₂Cl and CH₃NH₃SnF₂Cl.

The photoactive perovskite may be selected from CH₃NH₃PbBrI₂, CH₃NH₃PbBrCl₂, CH₃NH₃PbIBr₂, CH₃NH₃PbICl₂, CH₃NH₃PbClBr₂, CH₃NH₃PbI₂Cl, CH₃NH₃SnF₂Br, CH₃NH₃SnICl₂, CH₃NH₃SnF₂I, CH₃NH₃SnI₂Cl and CH₃NH₃SnF₂Cl.

The photoactive perovskite may be selected from CH₃NH₃PbBrI₂, CH₃NH₃PbBrCl₂, CH₃NH₃PbIBr₂, CH₃NH₃PbICl₂, CH₃NH₃PbClBr₂, CH₃NH₃PbI₂Cl, CH₃NH₃SnF₂Br, CH₃NH₃SnF₂I and CH₃NH₃SnF₂Cl.

The photoactive perovskite may be selected from CH₃NH₃PbBrI₂, CH₃NH₃PbBrCl₂, CH₃NH₃PbIBr₂, CH₃NH₃PbICl₂, CH₃NH₃SnF₂Br, and CH₃NH₃SnF₂I. The perovskite may be CH₃NH₃PbCl₂I.

The photoactive perovskite may be selected from CH₃NH₃PbI₃, CH₃NH₃PbBr₃, CH₃NH₃PbCl₃, CH₃NH₃PbF₃, CH₃NH₃PbBrₓI₃₋ₓ, CH₃NH₃PbBrₓCl₃₋ₓ, CH₃NH₃PbIₓBr₃₋ₓ, CH₃NH₃PbIₓCl₃₋ₓ, CH₃NH₃PbClₓBr₃₋ₓ, CH₃NH₃PbI₃₋ₓClₓ, CH₃NH₃SnI₃, CH₃NH₃SnBr₃, CH₃NH₃SnCl₃, CH₃NH₃SnF₃, CH₃NH₃SnBrI₂, CH₃NH₃SnBrₓI₃₋ₓ, CH₃NH₃SnBrₓCl₃₋ₓ, CH₃NH₃SnF₃₋ₓBrₓ, CH₃NH₃SnIₓBr₃₋ₓ, CH₃NH₃SnIₓCl₃₋ₓ, CH₃NH₃SnF₃₋ₓIₓ, CH₃NH₃SnClₓBr₃₋ₓ, CH₃NH₃SnI₃₋ₓClₓ and CH₃NH₃SnF₃₋ₓ, ClₓCH₃NH₃CuI₃, CH₃NH₃CuBr₃, CH₃NH₃CuCl₃, CH₃NH₃CuF₃, CH₃NH₃CuBrI₂, CH₃NH₃CuBrₓI₃₋ₓ, CH₃NH₃CuBrₓCl₃₋ₓ, CH₃NH₃CuF₃₋ₓBrₓ, CH₃NH₃CuIₓBr₃₋ₓ, CH₃NH₃CuIₓCl₃₋ₓ, CH₃NH₃CuF₃₋ₓIₓ, CH₃NH₃CuClₓBr₃₋ₓ, CH₃NH₃CuI₃₋ₓClₓ and CH₃NH₃CuF₃₋ₓClₓ, ClₓCH₃NH₃GeI₃, CH₃NH₃GeBr₃, CH₃NH₃GeCl₃, CH₃NH₃GeF₃, CH₃NH₃GeBrI₂, CH₃NH₃GeBrₓI₃₋ₓ, CH₃NH₃GeBrₓCl₃₋ₓ, CH₃NH₃GeF₃₋ₓBrₓ, CH₃NH₃GeIₓBr₃₋ₓ, CH₃NH₃GeIₓCl₃₋ₓ, CH₃NH₃GeF₃₋ₓIₓ, CH₃NH₃GeClₓBr₃₋ₓ, CH₃NH₃GeI₃₋ₓClₓ and CH₃NH₃GeF₃₋ₓClₓ where x is from 0 to 3. x may be from 0.05 to 2.96. For instance, x may be from 0.1 to 2.9, or from 0.5 to 2.5. In some cases, x is from 0.75 to 2.25, or from 1 to 2.

The photoactive perovskite employed in the device of the invention may comprise a mixed-halide perovskite and a single-halide perovskite, for instance in a blend, wherein said single-halide perovskite comprises a first cation, a second cation and a halide anion; wherein the first and second cations are as hereinbefore defined. For instance, the optoelectronic device may comprise: CH₃NH₃PbICl₂ and CH₃NH₃PbI₃; CH₃NH₃PbICl₂ and CH₃NH₃PbBr₃; CH₃NH₃PbBrCl₂ and CH₃NH₃PbI₃; or CH₃NH₃PbBrCl₂ and CH₃NH₃PbBr₃.

Alternatively, the photoactive perovskite employed in the device of the invention may comprise more than one metal halide perovskite, wherein each perovskite is a mixed-halide perovskite, and wherein said mixed-halide perovskite is as herein defined. For instance, the photoactive perovskite may comprise two or three said perovskites. The semiconductor may, for instance, comprise two perovskites wherein both perovskites are mixed-anion perovskites. For instance, the optoelectronic device may comprise: CH₃NH₃PbICl₂ and CH₃NH₃PbIBr₂; CH₃NH₃PbICl₂ and CH₃NH₃PbBrI₂; CH₃NH₃PbBrCl₂ and CH₃NH₃PbIBr₂; or CH₃NH₃PbBrCl₂ and CH₃NH₃PbIBr₂.

When [B] is a single metal cation which is Pb²⁺, one of said two or more different halide anions may be iodide or fluoride; and when [B] is a single metal cation which is Sn²⁺ one of said two or more different halide anions may be fluoride. One of said two or more different halide anions may be iodide or fluoride. One of said two or more different halide anions may be iodide and another of said two or more different halide anions may be fluoride or chloride. One of said two or more different halide anions may be fluoride. One of said two or more different anions may be fluoride and another of said two or more different anions may be chloride, bromide or iodide. One of said two or more different anions may be iodide and another of said two or more different anions may be fluoride or chloride. [X] may be two different halide anions X and X'. Said divalent metal cation may be Sn²⁺. Said divalent metal cation may be Pb²⁺.

The metal halide perovskite may be doped. For instance, the metal halide perovskite may be doped by the introduction of an impurity atom. For instance, the metal halide perovskite could be doped with a metal impurity of a different charge from the other metals in the perovskite. Thus, the perovskite could further comprise metal dopant selected from metals with an oxidation state of IV, III or I, for instance bismuth (III), antimony (III), tin (IV) or thallium (I).

The photoactive perovskite employed in the device of the invention preferably has a band gap which is narrow enough to allow the excitation of electrons by incident light. A band gap of 3.0 eV or less is particularly preferred, especially when the device is a photovoltaic device, because such a band gap is low enough for sunlight to excite electrons across it.

Accordingly, the photoactive perovskite employed in device of the invention typically has a band gap of equal to or less than 3.0 eV. In some embodiments, the band gap of the perovskite is less than or equal to 2.8 eV, for instance equal to or less than 2.5 eV. The band gap may for instance be less than or equal to 2.3 eV, or for instance less than or equal to 2.0 eV.

Usually, the band gap is at least 0.5 eV. Thus, the band gap of the perovskite may be from 0.5 eV to 2.8 eV. In some embodiments it is from 0.5 eV to 2.5 eV, or for example from 0.5 eV to 2.3 eV. The band gap of the perovskite may for instance be from 0.5 eV to 2.0 eV. In other embodiments, the band gap of the perovskite may be from 1.0 eV to 3.0 eV, or for instance from 1.0 eV to 2.8 eV. In some embodiments it is from 1.0 eV to 2.5 eV, or for example from 1.0 eV to 2.3 eV. The band gap of the metal perovskite may for instance be from 1.0 eV to 2.0 eV.

The photoactive perovskite may have a band gap of less than or equal to 3.0 eV. The metal halide perovskite may have a band gap of less than or equal to 2.0 eV.

### Device structure

In a semiconductor device according to the invention comprising a photoactive region, which photoactive region comprises a photoactive material, the charge-transporting layer is typically as defined above for the charge-transporting layer comprising first and second sub-layers and the photoactive material is typically in contact with the first sub-layer of the charge-transporting layer.

Preferably, the photoactive region comprises:
(a) said charge-transporting layer;
(b) said photoactive material; and
(c) a mesoporous scaffold layer, comprising a mesoporous dielectric scaffold material or a mesoporous charge-transporting scaffold material,
wherein the photoactive material is disposed between said charge-transporting layer and the mesoporous scaffold layer.

The photoactive material is typically disposed in pores of the mesoporous scaffold layer.

The charge transporting layer is typically a hole-transporting layer, and the mesoporous scaffold layer typically comprises a mesoporous dielectric scaffold material or a mesoporous n-type scaffold material.

The semiconductor device, for instance a photovoltaic device, may be have an inverse device architecture. Thus, alternatively, the charge transporting layer may be an electron-transporting layer, and the mesoporous scaffold layer may comprise a mesoporous dielectric scaffold material or a mesoporous p-type scaffold material.

The photoactive region typically further comprises: (d) a compact layer of a semiconductor, disposed between said mesoporous scaffold layer and one of the electrodes.

Preferably the charge-transporting layer is a hole-transporting layer, the mesoporous scaffold layer comprises a mesoporous dielectric scaffold material or a mesoporous n-type scaffold material, and the compact layer is a compact layer of an n-type semiconductor.

The semiconductor device, for instance a photovoltaic device, may be have an inverse device architecture. Thus, p-type and n-type components may be inverted. Alternatively, therefore, the charge-transporting layer is an electron-transporting layer, the mesoporous scaffold layer comprises a mesoporous dielectric scaffold material or a mesoporous p-type scaffold material, and the compact layer is a compact layer of an p-type semiconductor.

The mesoporous dielectric scaffold material is typically an oxide of aluminium, germanium, zirconium, silicon, yttrium or ytterbium; or alumina silicate.

The mesoporous n-type scaffold material is typically a mesoporous oxide of titanium, tin, zinc, niobium, tantalum, tungsten, indium, gallium, neodymium, palladium, cadmium, or a mesoporous oxide of a mixture of two or more of said metals; a mesoporous sulphide of cadmium, tin, copper, zinc or a mesoporous sulphide of a mixture of two or more of said metals; a mesoporous selenide of cadmium, zinc, indium, gallium or a mesoporous selenide of a mixture of two or more of said metals; or a mesoporous telluride of cadmium, zinc, cadmium or tin, or a mesoporous telluride of a mixture of two or more of said metals.

The n-type semiconductor of the compact layer, when present, is typically an oxide of titanium, tin, zinc, niobium, tantalum, tungsten, indium, gallium, neodymium, palladium, cadmium, zirconium or an oxide of a mixture of two or more of said metals; a sulphide of cadmium, tin, copper, zinc or a sulphide of a mixture of two or more of said metals; a selenide of cadmium, zinc, indium, gallium or a selenide of a mixture of two or more of said metals; or a telluride of cadmium, zinc, cadmium or tin, or a telluride of a mixture of two or more of said metals.

If device is inverted, the p-type semiconductor is typically an inorganic hole transporter. For instance, the p-type layer may comprise an inorganic hole transporter comprising an oxide of nickel, vanadium, copper or molybdenum; Cul, CuBr, CuSCN, Cu₂O, CuO or CIS; a perovskite; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped.

Preferably the mesoporous scaffold layer comprises mesoporous alumina. Preferably the compact layer is a compact layer of titanium dioxide. Preferably the photoactive material comprises a perovskite as defined herein.

The photoactive region typically comprises:
(a) an n-type region comprising at least one layer of an n-type material;
(b) a p-type region comprising at least one layer of a p-type material; and, disposed between the n-type region and the p-type region:
(c) a layer of the photoactive material,
wherein said charge-transporting layer is a layer of a p-type material in said p-type region or a layer of an n-type material in said n-type region. Preferably said charge-transporting layer is a layer of a p-type material in said p-type region.

The n-type region may comprise at least one layer of an n-type material selected from a metal oxide, a metal sulphide, a metal selenide, a metal telluride, a perovskite, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped. For instance the n-type region may comprise a metal oxide, for instance titanium dioxide.

Preferably the layer of the photoactive material forms a planar heterojunction with the n-type region or the p-type region. More preferably the layer of the photoactive material forms a first planar heterojunction with the n-type region and a second planar heterojunction with the p-type region.

In one embodiment, the semiconductor device does not comprise elemental silicon. Elemental silicon is a material in which the silicon is not in the form of a compound. Thus, elemental silicon includes solid silicon (whether crystalline or amorphous), but does not include silica (SiO₂).

The semiconductor device typically comprises a first electrode and a second electrode. The first and second electrode may comprise any suitable electrically conductive material. The first electrode typically comprises a transparent conducting oxide and/or the second electrode comprises a metal. Often the first electrode typically comprises a transparent conducting oxide and the second electrode comprises a metal. The transparent conducting oxide may be as defined above and is often FTO, ITO, or AZO, and typically ITO. The metal may be any metal. Generally the second electrode comprises a metal selected from silver, gold, copper, aluminium, platinum, palladium, or tungsten. The electrodes may form a single layer or may be patterned.

A semiconductor device according to the invention, for instance a sensitized solar cell, may comprises the following layers in the following order:
I. a first electrode as defined herein;
II. optionally a compact layer of a semiconductor material as defined herein;
III. a layer of a semiconductor material (which is preferably mesoporous);
IV. a layer of a sensitizer (e.g. a dye or a photoactive perovskite);
V. a p-type region comprising said charge-transporting layer;
VI. optionally a further compact layer of a semiconductor material as defined herein; and
VII. a second electrode as defined herein.

A semiconductor device according to the invention may comprises the following layers in the following order:
I. a first electrode as defined herein;
II. an n-type region comprising at least one n-type layer;
III. a layer of a photoactive perovskite without open porosity;
IV. a p-type region comprising said charge-transporting layer; and
V. a second electrode as defined herein.

A semiconductor device according to the invention may comprises the following layers in the following order:
I. a first electrode which comprises a transparent conducting oxide, preferably FTO;
II. an n-type region comprising at least one n-type layer;
III. a layer of a photoactive perovskite without open porosity;
IV. a p-type region comprising said charge-transporting layer; and
V. a second electrode which comprises a metal, preferably silver or gold.

A semiconductor device according to the invention may comprises the following layers in the following order:
I. a second electrode as defined herein;
II. an n-type region comprising at least one n-type layer;
III. a layer of a photoactive perovskite without open porosity;
IV. a p-type region comprising said charge-transporting layer; and
V. a first electrode as defined herein.

A semiconductor device according to the invention, for instance a sensitized solar cell, may comprises the following layers in the following order
I. a second electrode which comprises a metal;
II. an n-type region comprising at least one n-type layer;
III. a layer of a photoactive perovskite without open porosity;
IV. a p-type region comprising said charge-transporting layer; and
V. a first electrode which comprises a transparent conducting oxide.

The first electrode may have a thickness of from 100 nm to 700 nm, for instance of from 100 nm to 400 nm. The second electrode may have a thickness of from 10 nm to 500 nm, for instance from 50 nm to 200 nm. The n-type region may have a thickness of from 50 nm to 500 nm. The p-type region may have a thickness of from 50 nm to 500 nm.

The layer of a perovskite typically has a thickness of from 50 nm to 1000 nm, or for instance from 100 nm to 700 nm. The thickness of the layer of the perovskite semiconductor is often greater than 100nm.

The thickness of said component for transporting charge may be from 50 nm to 1000 nm. For instance, the thickness of said component for transporting charge may be from 100 nm to 500 nm.

### Device type

The semiconductor device may be an optoelectronic device, a battery, a triode, a diode, a capacitor or a transistor. For instance, the semiconductor device may be a light emitting device, a light emitting diode, an optically pumped laser, an electrical injection laser or a transistor.

Preferably, the semiconductor device is a optoelectronic device. More preferably, the semiconductor device is a photovoltaic device. The photovoltaic device may be a photodiode, a solar cell, a photodetector, a photosensor or a chromogenic device.

### Process for producing a device

The invention provides a process for producing a semiconductor device, which semiconductor device comprises a component for transporting charge, which component comprises an electrically insulating matrix and, disposed in said matrix, carbon nanotubes functionalized with a semiconducting polymer, which process comprises:
(a) providing a substrate and, disposed on a surface of the substrate, carbon nanotubes functionalized with a semiconducting polymer; and
(b) disposing an electrically insulating matrix onto the carbon nanotubes functionalized with a semiconducting polymer.

The semiconductor device is typically an optoelectronic device, for instance a photovoltaic device.

Each of the components in the process may be as described herein. For instance the CNTs are typically SWNTs. The semiconducting polymer is typically a poly(alkylthiophene). The electrically insulating matrix typically comprises an electrically insulating organic such as a poly(carbonate), a poly(acrylate) or a poly(methacrylate).

Typically, the mass of said carbon nanotubes functionalized with a semiconducting polymer disposed on the surface of the substrate, per unit area of the surface, is at least 3 µg/cm². Preferably, the mass of said carbon nanotubes functionalized with a semiconducting polymer disposed on the surface of the substrate, per unit area of the surface, may be at least 6 µg/cm². The mass of said carbon nanotubes functionalized with a semiconducting polymer disposed on the surface of the substrate, per unit area of the surface, may be from 3 µg/cm² to 20 µg/cm², and optionally from 5 µg/cm² to 15 µg/cm².

Typically the process further comprises disposing the functionalised nanotubes on the substrate. Thus, the process may comprise:
(a) disposing said carbon nanotubes functionalized with a semiconducting polymer on the surface of the substrate; and
(b) disposing an electrically insulating matrix onto the carbon nanotubes functionalized with a semiconducting polymer.

The functionalized CNTs are typically solution deposited on the surface of the substrate. One of the benefits of the functionalization of the CNTs is that they may be dispersed in solution. Typically, therefore, the step of (a) disposing said carbon nanotubes functionalized with a semiconducting polymer on the surface of the substrate comprises:
(a1) disposing a composition comprising a solvent and said carbon nanotubes functionalized with a semiconducting polymer on the surface of the substrate; and
(a2) removing the solvent.

The solvent may be removed by any suitable means. Typically the solvent is removed by heating or allowing the solvent to evaporate. For instance the substrate may be heated at a temperature of from 30°C to 80°C. Alternatively the solvent may be allowed to evaporate under ambient conditions. In some cases, the solvent will not be removed until after the next layer has been disposed on top of the CNTs, for instance the electrically insulating matrix layer.

The solvent for disposing the functionalized CNTs is typically a polar solvent. Preferably the solvent is a polar aprotic solvent. For instance the solvent may be chloroform, chlorobenzene or dimethylformamide.

Typically, (a1) comprises disposing the composition on the surface of the substrate by spin-coating, slot-die-coating or spray coating. Preferably the composition comprising a solvent and the functionalized CNTs is disposed on the surface of the substrate by spin-coating. More preferably the composition is disposed by drop-by-drop spin-coating or dynamic spin-coating. Drop-by-drop spin-coating and dynamic spin-coating typically comprise disposing the composition onto the substrate while the substrate is already spinning, for instance at from 1000 to 3000 rpm.

The process may further comprise producing the CNTs functionalized with a semiconducting polymer. Typically, the CNTs functionalized with a semiconducting polymer are produced by treating the CNTs with a solution of the semiconducting polymer. Thus, the process may further comprise producing the carbon nanotubes functionalized with a semiconducting polymer by:
(i) preparing a composition comprising carbon nanotubes, a solvent and, dissolved in the solvent, said semiconducting polymer;
(ii) agitating the composition, optionally by sonicating the composition;
(iii) separating solid material from the composition, which solid material comprises non-functionalized carbon nanotubes and carbonaceous particles, and recovering the supernatant;
(iv) treating the supernatant to induce aggregation of carbon nanotubes functionalized with the semiconducting polymer, optionally by heating the supernatant and/or by adding a further solvent to the supernatant;
(v) recovering the aggregated carbon nanotubes functionalized with the semiconducting polymer;
(vi) washing the carbon nanotubes functionalized with the semiconducting polymer with a solvent, to remove any free semiconducting polymer;
(vii) recovering the carbon nanotubes functionalized with the semiconducting polymer; and
(viii) optionally repeating (vi) and (vii).

In step (i), the solvent may be a polar solvent, for instance a polar aprotic solvent, as defined above. In step (ii), sonication may be performed for from 1 to 20 minutes, typically from 8 to 12 minutes. In step (iii), separating may be performed by centrifuging the mixture, for instance at from 10,000 to 20,000 g for from 1 to 10 minutes. In step (iv), the further solvent may be a non-polar solvent, for instance toluene. In step (vi), the solvent may be a non-polar solvent, for instance toluene. Step (viii) may comprise repeating (vi) and (vii) two or three times.

Typically, the step of (b) disposing an electrically insulating matrix onto the carbon nanotubes functionalized with a semiconducting polymer comprises:
(b1) disposing onto said carbon nanotubes functionalized with a semiconducting polymer a composition comprising a solvent and said electrically insulating matrix; and
(b2) removing the solvent.

The electrically insulating matrix may be as defined herein and the carbon nanotubes functionalized with a semiconducting polymer may be as defined herein. The solvent may be as defined herein. The solvent is typically a polar solvent. Removing the solvent may be as described above. For instance the solvent may be heated or allowed to evaporate.

Typically, the electrically insulating matrix comprises an electrically insulating organic polymer and the step of (b) disposing an electrically insulating matrix onto the carbon nanotubes functionalized with a semiconducting polymer comprises:
(b1) disposing onto said carbon nanotubes functionalized with a semiconducting polymer a composition comprising a solvent and said electrically insulating organic polymer; and
(b2) removing the solvent.

The electrically insulating organic polymer is typically dispersed or dissolved in the solvent. Preferably the polymer is dissolved in the solvent.

Alternatively, the electrically insulating organic polymer may be formed in sit by disposing one or more monomers on the functionalized CNTs. Thus, the electrically insulating matrix may comprise an electrically insulating organic polymer and the step of (b) disposing an electrically insulating matrix onto the carbon nanotubes functionalized with a semiconducting polymer may comprise:
(b1) disposing onto said carbon nanotubes functionalized with a semiconducting polymer a composition comprising one or more monomers suitable for producing an electrically insulating organic polymer; and
(b2) polymerising said monomers, and thereby producing said electrically insulating organic polymer.

Polymerising said monomers may comprise curing the monomers by exposing the monomers to heat, light, radiation or a chemical curing agent. Alternatively said monomers may be allowed to cure.

The electrically insulating matrix may comprise an electrically insulating organic polymer and the step of (b) disposing an electrically insulating matrix onto the carbon nanotubes functionalized with a semiconducting polymer may comprise:
(b1) disposing onto said carbon nanotubes functionalized with a semiconducting polymer a composition comprising an uncured precursor to an electrically insulating organic polymer; and
(b2) curing said composition, and thereby producing said electrically insulating organic polymer.

Typically (b1) comprises disposing the composition onto said carbon nanotubes functionalized with a semiconducting polymer by spin-coating, slot-die-coating or spray coating. Preferably the composition comprising the electrically insulating polymer (or monomers or precursors thereof) is disposed on the surface of the substrate by spin-coating. More preferably the composition is disposed by drop-by-drop spin-coating or dynamic spin-coating.

As discussed above, it is often preferably to have charge transporting component which comprises two sub-layers. Thus, in the process of the invention, the step of (b) disposing an electrically insulating matrix onto the carbon nanotubes functionalized with a semiconducting polymer may comprise:
- disposing the electrically insulating matrix onto the carbon nanotubes to form a first sub-layer, which first sub-layer comprises said electrically insulating matrix and, disposed in said electrically insulating matrix at a first concentration, said carbon nanotubes functionalized with a semiconducting polymer; and
- continuing to dispose the electrically insulating matrix to form a second sub layer on the first sub-layer, wherein the second sub-layer comprises said electrically insulating matrix and, disposed in said electrically insulating matrix at a second concentration, said carbon nanotubes functionalized with a semiconducting polymer,
wherein the second concentration is less than the first concentration. The second concentration may be 20% greater than the first concentration. The concentration may be measured as a mass density (e.g. µg/cm³).

### Substrate

In the process for producing a semiconductor device according to the invention, the substrate may be any suitable substrate. The substrate will typically comprise a number of layers. The substrate may comprise one or more layers of a semiconducting material or a photoactive material. The substrate preferably comprises a layer of a photoactive material.

Typically, the substrate comprises a photoactive material and said surface of the substrate on which the carbon nanotubes functionalized with a semiconducting polymer are disposed is a surface of the photoactive material. The photoactive material in the substrate may be as defined herein. In particular, the photoactive material may comprise a photoactive perovskite. The photoactive perovskite may be as defined herein. The photoactive material may be a mixed halide perovskite.

The substrate may further comprises a mesoporous scaffold layer, wherein said photoactive material is disposed on the mesoporous scaffold layer, which mesoporous scaffold layer comprises a mesoporous dielectric scaffold material or a mesoporous charge-transporting scaffold material. The mesoporous scaffold layer may be as defined herein. For instance, the mesoporous scaffold layer may comprise mesoporous aluminium oxide (alumina) or titanium dioxide (titania).

The substrate may further comprise a compact layer of a semiconductor. The substrate may further comprise a compact layer of a semiconductor, wherein the mesoporous scaffold layer is disposed on said compact layer. The compact layer may be as defined herein. Thus, the compact layer may be a compact layer of an n-type semiconductor, for instance titanium dioxide.

Typically, the substrate further comprises an n-type region comprising at least one layer of an n-type material, or a p-type region comprising at least one layer of a p-type material, wherein said photoactive material is disposed on the n-type region or the p-type region. The photoactive material may form a planar heterojunction with the n-type region or the p-type region on which it is disposed. The n-type region and p-type region may be as defined herein.

The substrate typically further comprises an electrode material (which is a first electrode material). The first electrode material preferably comprises a transparent conducting oxide. The first electrode material is typically a transparent conducting oxide. The transparent conducting oxide may be selected from ITO, FTO and AZO.

The substrate may further comprise a supporting material, for instance glass. Thus, the substrate may comprise one or more of the following layers in the following order:
A. a supporting material, for instance glass;
B. an electrode material, for instance a transparent conducting oxide;
C. a compact layer of an n-type semiconductor;
D. a mesoporous scaffold layer; and
E. a layer of a photoactive material.

The process for producing a semiconductor device typically further comprises (c) disposing a counter electrode material on the component for transporting charge. The counter electrode material (a second electrode material) typically comprises a metal. For instance, the counter electrode material may be a metal. The metal may be any suitable metal. The metal may be selected from silver, gold, copper, aluminium, platinum, palladium, or tungsten. Preferably the counter electrode material comprises silver or gold. The counter electrode material may be disposed by vacuum evaporation.

The semiconductor device produced by the process of the invention may be as defined hereinbefore.

### Semiconductor device

The invention also provides a semiconductor device which is obtainable by a process as defined herein. Typically, the semiconductor device is an optoelectronic device, and preferably a photovoltaic device.

The invention will be further described in the Examples which follow.

### EXAMPLES

### Methods and materials

### SWNT functionalization

Powdered singled-walled carbon nanotubes (SWNTs) produced by the HiPCO (high pressure carbon monoxide) process were purchased from Carbon Nanotechnologies Incorporated (CNI; now Unidym) with lengths 100-1000 nm and an intermediate diameter distribution of 0.8-1.2 nm. The samples used in this work were purchased as 'purified' tubes (<15 wt % iron catalyst impurities). 3.0 mg of rr-P3HT (Rieke Metals Inc., weight average molecular weight, Mw = 50 000 g mol⁻¹ and regioregularity = 95%) was dissolved in 5.00 mL of chlorobenzene and sonicated in a ultrasonic bath for 60 min. 2.5 mg purified HiPCO SWNTs were added as purchased to the dissolved polymer solution and treated with a ultrasonic probe for 10 min. The mixture was subsequently centrifuged for 8 min at 10,000 g to remove non-functionalized SWNTs and other carbonaceous particles. The precipitate was discarded while the supernatant was recovered. In order to remove the excess polymer according to the solvent extraction technique detailed by Schuettforth et al. (Schuettfort, T., Snaith, H. J., Nish, A. & Nicholas, R. J. Synthesis and spectroscopic characterization of solution processable highly ordered polythiophene-carbon nanotube nanohybrid structures. Nanotechnology 21, 25201 (2010)) 15 ml of toluene were added. The mixture was then mildly heated for 60 min to induce aggregation of the functionalized SWNTs. The aggregates were then removed by centrifugation (4 min at 16,000 g). This time the supernatant containing excess polymer was discarded and the precipitate was recovered and redispersed in 5 ml of toluene. This mixture was then sonicated for 15 min in the ultrasonic bath to fully redisolve non-wrapped polymers. After the sonication, the mixture was mildly heated for 15 min to induce aggregation and then centrifuged for 4 min at 16,000 g. The supernatant was then discarded. This procedure from bath sonication to centrifugation was repeated three times to remove all excess polymer resulting in the final supernatant being fully transparent. The final pellet consisted of 2.0 - 2.2 mg of functionalized nanotubes which were dispersed in 16 ml chloroform. Immediately prior to spincoating, the chloroform solution was sonicated with a ultrasonic probe for 2 min at low intensity (∼10% of amplitude) to break up clusters and bundles.

### Solar cell fabrication

A glass waver with a layer of fluorine doped tin oxide (FTO) was first cleaned with detergent and de-ionized water, then with acetone and isopropanol. Thereafter it was treated for 10 min in O₂ plasma. The electron accepting TiO₂ compact layer was spin-coated from an ethanol based precursor solution and sintered at 500°C. The low-temperature meso- structured scaffold was afterwards deposited by spin-coating from a colloidal dispersion of 20 nm Al₂O₃ nanoparticles in isopropanol followed by drying at 150°C. After having cooled down to room temperature, the perovskite layer was spin-cast and dried at 100°C for 45 min. Following this step, the hole transport layer was deposited by spin-coating. For the double structure of SWNT and organic hole transporter (spiro-OMeTAD) or electrically insulating material (PMMA), first the SWNT layer was deposited dynamically by slow drop-by-drop spin-coating (3000 rpm) of 200 µl of a solution of functionalized SWNTs in chloroform. This was followed immediately by the deposition of the organic hole transporter (spiro-OMeTAD) or electrically insulating material (PMMA) also by spin-coating (2000 rpm, 2000 rpm/s). Electrodes were deposited through evaporation of 150 nm of Ag.

### Current-voltage measurements

For measuring the performance of the solar cells, simulated AM 1.5 sunlight was generated with a class AAB ABET solar simulator calibrated to give simulated AM 1.5, of between 100 to 106.5 mW cm⁻² equivalent irradiance, using an NREL-calibrated KG5 filtered silicon reference cell. The mismatch factor was calculated to be 1.01 between 300 to 900 nm, which is beyond the operating range of both the KG5 filtered silicon reference cell and the perovskite test cells. The current-voltage curves were recorded with a sourcemeter (Keithley 2400, USA). The solar cells were masked with a metal aperture defining the active area (0.063 cm²) of the solar cells. Additionally, by removing active material between individual pixels, single-pixel contributions was ensured. In the course of recalibrating the solar simulator in order to reduce the mismatch factor to 1.0, the intensity was adjusted to 100 mWcm⁻². Previously obtained efficiency values have been normalized accordingly.

### Photoinduced absorption spectroscopy

Photoinduced absorption (PIA) spectra were obtained from full device structures with varying hole transport layer architectures. These samples were excited with an argon ion laser with a wavelength of 515 nm with a maximum fluence of 50 mW cm⁻² and chopped at a frequency of 23 Hz. The optical probe is in the form of a white light halogen bulb of around 1 sun intensity. After passing through the sample, the probe beam enters a monochromator (SpectraPro- 2300i, Acton Research Corporation) coupled to diode for detection in the visible (PDA10A, Thorlabs) and in the NIR (ID-441-C, Acton Research Corporation). Acquisition is made by a lock-in amplifier locked at the light modulation frequency (SR830, Stanford Research Systems) and a NI USB-6008 (National Instruments) acquisition card. A computer running LabView (National Instruments) controls the setup and record spectra. No further treatment is applied to the data.

### Reference Example 1 - Functionalized CNT/organic hole transporter composite

The inventors assessed whether the addition of the functionalized SWNTs to the spiro-OMeTAD layer improved the hole-conductivity. In Table 1 the conductivity of a range of films is shown, where very high lateral conductivity was observed in the neat SWNT film, and enhanced conductivity in the spiro-OMeTAD SWNT blend, in comparison to the neat spiro-OMeTAD film. No dopants were added to the spiro-OMeTAD results are compared to films of neat spiro-OMeTAD.

**Table 1: Lateral conductivity of different hole transport layer architectures.**

| **HTL architecture** | **Conductivity [S/cm]** |
|---|---|
| spiro-OMeTAD (neat) | 2.1 · 10⁻⁷ |
| spiro-OMeTAD (*t*BP+Li-TFSI) | 6.1 · 10⁻⁶ |
| SWNT-spiro-OMeTAD (blend) | 2.2 ·10⁻⁶ |
| SWNTs (neat) | 4.6 ·10⁻² |

Lateral conductivity through spiro-OMeTAD films with the addition of SWNTs was measured, but that may not necessarily lead to an enhanced device performance. The current-voltage characteristics for devices employing no hole-transport layer, neat spiro-OMeTAD and the SWNT-spiro-OMeTAD composite are shown in Figure 3.

The device with no p-type collection layer, i.e. direct contact of the hole-collecting electrode to the perovskite exhibits very poor characteristics, with specifically low short-circuit photocurrent. This suggests that direct metallic contact to the CH₃NH₃PbI₃₋ₓClₓ perovskite in the MSSC structure, where both electrons and holes reside within the perovskite, is not advantageous. In contrast, in a different device architecture in which the scaffold for the perovskite is made of electron accepting TiO₂ instead of alumina, gold can be used for direct hole-collection. This is presumably due to the rapid electron transfer to the mesoporous TiO₂ competing more favorably than electron transfer to the gold electrode in that configuration. In our devices however, electron transfer from the perovskite to the metal electrode is likely to occur, constituting a recombination pathway. A significant improvement is therefore seen when undoped spiro-OMeTAD is used as hole-collection layer, which despite the low conductivity in the spiro-OMeTAD film, can still deliver a device with up to 13 mAcm⁻² photocurrent, but only 4.1% efficiency due to a low voltage and fill factor. Dispersing P3HT/SWNTs in the spiro-OMeTAD layer significant increases the extracted photocurrent, as well as fill factor and open-circuit voltage. This enhancement of performance parameters results in more than doubling of the efficiency to 10.0%. The randomly dispersed nanotubes appear to noticeably enhance charge transport throughout the spiro-OMeTAD layer, yet with a fill-factor of merely 0.54, the solar cell remains limited by series resistance. This is in line with the much lower conductivity of the blend film itself, compared to the neat P3HT/SWNT film. This indicates that its conductivity may still be a limiting factor. It is suspected that the nanotubes in this configuration cannot effectively form a closely interconnected percolation network.

As shown in Figure 3 and Table 2 below, the presence of spiro-OMeTAD as hole transport layer (HTL) leads to a significant improvement in efficiency compared to the device without HTL. Dispersing SWNTs in the spiro-OMeTAD layer further improve the JV-characteristics. However, the biggest improvement is achieved by sequential deposition of SWNTs and spiro-OMeTAD, which results in a stratified HTL structure.

**Table 2: performance parameters of devices with different hole transport layers. These include two approaches of incorporating SWNTs into the spiro-OMeTAD layer and two control structures.**

| **HTL architecture** | **J_{sc} [mA/cm²]** | **V_{oc} [V]** | **FF** | **PCE [%]** |
|---|---|---|---|---|
| no HTL | 2.4 | 0.68 | 0.53 | **0.8^{a)}** |
| spiro-OMeTAD | 13.1 | 0.88 | 0.38 | **4.1^{a)}** |
| SWNT-spiro-OMeTAD (blend) | 12.4 | 0.97 | 0.54 | **10.0 ^{b)}** |
| SWNT-spiro-OMeTAD | 20.2 | 1.00 | 0.69 | **13.9 ^{b)}** |

| | | | | |
|---|---|---|---|---|
| a) obtained under simulated AM 1.5, of 106.5 mW/cm² equivalent irradiance b) obtained under simulated AM 1.5, of 100.0 mW/cm² equivalent irradiance | | | | |

Based on this finding, a second approach in which SWNTs and spiro-OMeTAD were spin-coated as two sequential layers was tried: the initial deposition of the SWNTs alone ensures that the nanotubes form a densely interconnected network with a direct interface with the perovskite layer allowing direct hole-transfer. A scanning electron micrograph of a top view of a bare SWNT layer showing the thick mesh-like structure of this layer is shown in Figure 2. Subsequent coating and infilling with spiro-OMeTAD enables hole-conductor contact to the perovskite and may facilitate additional direct hole-transfer to the electrode.

A scanning electron microscopy (SEM) image of a representative device cross-section is shown in Figure 1. SWNT bundles are apparent protruding from the interface between the Al₂O₃-perovskite and spiro-OMeTAD layer. It appears that spiro-OMeTAD readily infiltrates the SWNT layer filling the openings and gaps of the mesh-like nanotube layer, due to its excellent pore filling properties, and good wettability upon coating this surface. However, there is clearly stratification, with much higher SWNT density near the perovskite surface, which could potentially impair vertical hole percolation throughout the SWNTs to the hole accepting electrode. In addition, direct contact between perovskite and metallic type SWNTs may constitute recombination sites as discussed above. Nevertheless, the current-voltage characteristics of a device with such a sequentially coated stratified SWNT-spiro-OMeTAD composite layer are shown in figure 3. The solar cell exhibits good properties, with minimal indication of recombination or series resistance losses, and yields a power-conversion efficiency of 13.9%.

Uniformity and smoothness of the SWNT film appears to be an important aspect for device performance in this approach. The formation of large, mesoscopic SWNT bundles and clusters correlates with reduced device performance and batch consistency. It has been found that the most effective way of depositing SWNTs to form a uniform layer was to perform "dynamic spin-coating", as described above in the methods and materials section. The fact that the devices work so well indicated that direct contact of the P3HT-wrapped SWNTs to the perovskite surface does not introduce an undesired electron recombination pathway. From the reduced series resistance in the devices, it can be inferred that the SWNTs protrude through the spiro-OMeTAD frequently enough to make sufficient contact with the hole-collecting electrode (Au/Ag). However, it remains unclear whether charge transfer occurs between the nanotubes and spiro-OMeTAD, and to what extent the SWNTs transfer holes directly to the electrode.

In order to determine the operational mechanism, photoinduced absorption (PIA) spectroscopy was performed. PIA is a quasi-continuous-wave (CW) technique, which is useful to probe the optical signature of photogenerated species. If spiro-OMeTAD and P3HT-wrapped SWNTs exhibit different optical signatures when oxidized, PIA can be used to determine if holes are residing on either component or both. The PIA spectrum of a device with undoped spiro-OMeTAD HTL is shown in figure 4. The broad feature at ∼1300 nm is characteristic of the presence of holes in spiro-OMeTAD (i.e. its oxidized state). For the stratified SWNT-spiro-OMeTAD structure, the broad feature of oxidized spiro-OMeTAD becomes weaker and appears to be overlaid with a second, longer wavelength feature centered around 1450 nm. This suggests a smaller or shorter-lived hole population in the spiro-OMeTAD with the presence of SWNTs. To isolate the specific features of SWNTs in the PIA spectra, PIA measurements were carried out on devices with neat-SWNT films in place of spiro-OMeTAD. The resulting PIA spectrum is shown in Figure 5 together with the absorption spectrum of an SWNT film on glass. The absorption spectrum has the characteristic absorption peaks associated with the E₁₁ transitions of s-type SWNTs according to their chirality. In the PIA spectrum, a series of photobleaching (PB) features are observed, which perfectly coincide with bleaching of the ground state absorption of the SWNTs. The PIA absorption feature further into the infrared is most likely absorption of the oxidized SWNTs or electrons in the electron-accepting TiO₂ layer on the adjacent side of the perovskite film. The spectral features were confirmed by chemically p-doping SWNTs in solution. The spectral difference between the undoped and oxidized SWNTs revealed a spectrum very similar to the PIA spectrum.

### Example 1 - Functionalized CNTs embedded in an electrically insulating matrix

Since the PIA measurements indicated that the functionalized SWNTs can act as a hole-acceptor in their own right, the inventors explored the possibility of omitting the organic hole-conductor entirely and using only a layer of functionalized SWNTs for hole extraction. The JV-curve of such a device is shown in Figure 6. The extracted photocurrent is remarkably high indicating extremely efficient hole-transfer occurs through the nanotubes, despite their relatively low contact area with the perovskite. The low fill factor and voltage arise most likely from recombination losses due to direct contact of the metal electrode to the perovskite, through the gaps between the SWNT "mesh". Even so, the device still delivers an impressive 7.4% power conversion efficiency.

**Table 3: performance parameters of solar cells with only SWNTs as hole transporter**

| **HTL architecture** | **J_{sc} [mA/cm²]** | **V_{oc} [V]** | **FF** | **PCE [%]^{a)}** |
|---|---|---|---|---|
| SWNT(HiPCO) only | 20.8 | 0.85 | 0.42 | **7.4** |
| SWNT(HiPCO)-PMMA | 21.5 | 1.04 | 0.63 | **14.2** |
| SWNT(CG200)-PMMA | 22.7 | 1.02 | 0.66 | **15.3** |

| | | | | |
|---|---|---|---|---|
| a) obtained under simulated AM 1.5, of 100.0 mW/cm² equivalent irradiance | | | | |

The high extracted photocurrent appeared to indicate that the contribution of spiro-OMeTAD to the charge transfer in the stratified HTL structure is only minor or not necessary. The role of spiro-OMeTAD may be to simply infill the gaps between the SWNTs in order to prevent the metal electrode from directly contacting the perovskite. Spiro-OMeTAD was replaced with an electronically and optically inert polymer, poly(methyl methacrylate) (PMMA), and devices were constructed with sequential SWNT-PMMA films. The schematic architecture of such a device is shown in Figure 12. Because PMMA is not a π-conjugated polymer it is unable to support charge transport. The resulting current-voltage curve of the best functionalized SWNT-PMMA (stratified) device is shown in Figure 6, which exhibits a high power conversion efficiency of 14.2%. In this device, the functionalized SWNTs were produced by the HiPCO (High Pressure Carbon monoxide) process, yielding a ratio of 2:1 semiconducting to metallic nanotubes.

It was found that the presence of metallic species among the P3HT/SWNT nanohybrids does not introduce significant recombination losses, and since hole conductivity of the HTL is one of the crucial factors for efficient the charge collection, further devices were tested with a second type of metallic-enriched SWNTs (CoMoCAT, CG200). The more conductive SWNT species led to further improvement in solar cell performance by increasing the extracted photocurrent, thus yielding a power conversion efficiency of up to 15.3% (Figure 13, Table 4 below). It is evident that CNTs functionalized with a semiconducting polymer are highly efficient in selectively transferring charges from the photoactive perovskite layer to the electrode. Surprisingly, placing the functionalized CNTs within an electrically insulating matrix produces a very effective component for transporting charge.

**Table 4: performance parameters of devices comprising different hole transport materials**

| **HTL architecture** | **J_{sc}** | **V_{oc} [V]** | **FF** | **PCE** |
|---|---|---|---|---|
| P3HT/SWNT (HiPCO) only | 20.8 | 0.85 | 0.42 | **7.4** |
| P3HT/SWNT(HiPCO)-PMMA | 21.5 | 1.04 | 0.63 | **14.2** |
| P3HT/SWNT(CG200)-PMMA | 22.7 | 1.02 | 0.66 | **15.3** |

| | | | | |
|---|---|---|---|---|
| a) obtained under simulated AM 1.5, of 100.0 mW/cm² equivalent irradiance | | | | |

### Example 2 - Thermal stability of component for transporting charge

Photovoltaic devices comprising a charge transport layer comprising a poly(methyl methacrylate) (PMMA)/functionalized SWNT composite or a polycarbonate (PC)/functionalized SWNT composite were manufactured by the above described methods. While PMMA is not very stable at temperatures above 100°C, the much more robust polymer polycarbonate (PC) was investigated and found to be also an adequate encapsulating inert matrix with the advantage of being thermally stable up to 155°C.

The devices comprising these electrically insulating inert matrices were heated on a hot plate at 80°C for 96 hours. Both devices were found to be thermally stable for this period and had a peak power conversion efficiency of 14.3%. The current-voltage characteristics of the device comprising a polycarbonate matrix is shown in Figure 7. The characteristics of this device are: J_{SC} = 19.8 mAcm⁻²; V_{OC} = 1.03 V; FF = 0.70; and PCE = 14.3%.

The SWNT-polymer composite as hole transport layer on perovskite solar cells is superior to conventional hole transport materials with regards to thermal stability.

To compare devices comprising known hole transporting layers with the devices according to the invention, devices were fabricated with the following hole transporting materials: spiro-OMeTAD (+ Li-TFSI + tert-butyl pyridine); polytriarylamine (PTAA) (+ Li-TFSI + tert-butyl pyridine); and poly(3-hexylthiophene) (P3HT) (+ Li-TFSI + tert-butyl pyridine). These devices were placed on a hot plate for 96h at 80°C (in the same manner as for the PMMA and PC devices according to the invention) to test the encapsulating properties of the hole-transporting layer. Visually the films with spiro-OMeTAD, PTAA and P3HT had significantly degraded whereas the films with SWNT-PMMA and SWNT-PC as hole transport layer did not show any signs of degradation (Figure 8 and Figure 9). The degradation of the perovskite layer was correlated with a change of its absorption characteristic. The typical absorption across the visible range from 750 nm to 500 nm vanishes gradually for devices with Li-spiro-OMeTAD, P3HT or PTAA as hole-transporting layer, but remains unchanged for a device encapsulated by a hole-transporting structure consisting of functionalized SWNTs and a PMMA matrix (Figure 10). The degradation of devices with Li-spiro-OMeTAD, P3HT and PTAA is further illustrated by X-ray diffraction (XRD) measurements. The comparison of the XRD spectrum before and after 96 h of heat exposure at 80°C, shows that the material has lost the characteristic diffraction features of CH₃NH₃PbI₃₋ₓClₓ and now exhibits the features associated with PbI₂ (Figure 11). In contrast, the XRD spectrum of the device with the SWNT-PMMA composite structure shows no change before and after heat exposure. It was found accordingly that the devices with spiro-OMeTAD, PTAA or P3HT ceased to operate as efficient solar cells after the thermal degradation. In contrast, as described above, the devices with functionalized SWNT/insulating polymer composites as hole transport layers were fully functioning with a peak efficiency of 14.3% and show very stable batch behavior (Figure 14).

Further evidence for increased thermal stability of perovskite solar cells employing SWNT-insulating polymer hole-transporter components is given by measuring the solar cell performance when operating at higher temperatures (Figure 15). Thermal dependence of device performance was tested with a custom-built sample chamber, which was externally heated by placing it on a hot-plate. The temperature was measured on the device surface with an IR thermometer. Before measuring the photovoltaic performance of the devices under simulated sun light, they were held at each temperature point for 20 minutes in order to let them equilibrate. The performance of the devices was measured in the temperature range between 25°C and 100°C.

While the performance does drop for devices fabricated with both SWNT-PMMA and SWNT-PC hole-transporting components, the performance decrease is small and the solar cells recuperate their original performance after the thermal cycle. For devices employing Li-spiro-OMeTAD, P3HT and PTAA as the hole-transporters the degradation ismuch more pronounced and leads to irreversible damage to the devices, which accordingly do not recover after having cooled down to room temperature. In contrast, devices with SWNT-polymer matrices are still functioning after having been measured at temperatures of up to 100°C.

### Example 3 - Water resistance of component for transporting charge

Photovoltaic devices comprising a charge transport layer comprising a poly(methyl methacrylate) (PMMA)/functionalized SWNT composite or a polycarbonate (PC)/functionalized SWNT composite were manufactured by the above described methods. To test the water resistance of the encapsulating hole-transporting component, the complete devices were directly placed within a stream of running water. The photovoltaic performance of a device comprising a SWNT-PC hole-transporting component before and after having been exposed to running water for 60 s was measured (Figure 16). The performance does not change significantly (as shown in Table 5 below) which is evidence for the water resistance of this structure.

**Table 5: performance parameters of devices comprising different hole transport materials**

| **P3HT/SWNT-PC** | **J_{sc}** | **V_{oc} [V]** | **FF** | **PCE [%]** |
|---|---|---|---|---|
| Before water exposure | 22.6 | 0.94 | 0.6 | **12.9** |
| After water exposure | 22.9 | 0.94 | 0.6 | **12.7** |

The SWNT-polymer composite as hole transport layer on perovskite solar cells is superior to conventional hole transport materials with regards to water stability.

The work leading to this invention has received funding from the European Community's Seventh Framework Programme (FP7/2007-2013) under grant agreement no. 279881.

## Claims

1. A photovoltaic device comprising a component for transporting charge, which component comprises an electrically insulating matrix and, disposed in said matrix, carbon nanotubes functionalized with a semiconducting polymer.

2. A photovoltaic device according to claim 1 wherein the carbon nanotubes functionalized with a semiconducting polymer are dispersed within the electrically insulating matrix, and preferably are randomly dispersed within the electrically insulating matrix, and more preferably are randomly dispersed within a region or sub-layer of the electrically insulating matrix, or within the whole of the electrically insulating matrix.

3. A photovoltaic device according to claim 1 or claim 2 wherein the electrically insulating matrix comprises an electrically insulating organic material, or a dielectric inorganic material, preferably comprises an electrically insulating organic polymer, and more preferably comprises a poly(acrylate), a poly(methacrylate), a polyvinyl alcohol, a polystyrene, a polybutyrate, a polyimide or a polycarbonate.

4. A photovoltaic device according to any one of claims 1 to 3 wherein said carbon nanotubes are coated at least in part with the semiconducting polymer, and preferably are wrapped in the semiconducting polymer.

5. A photovoltaic device according to any one of the preceding claims wherein the semiconducting polymer is a conjugated polymer and/or a hole-transporting polymer, and preferably comprises a polythiophene, such as poly(3-hexylthiophene), poly(3-octylthiophene) or poly(3-dodecylthiophene); a polyfluorene, such as poly(9,9-dioctofluorene), poly(9,9-di-n-octylfluorene-alt-benzothiadiazole) or poly(indenofluorene); or a poly(phenylene vinylene).

6. A photovoltaic device according to any one of the preceding claims wherein the component for transporting charge is a charge-transporting layer, and preferably wherein said charge-transporting layer comprises a first sub-layer in contact with a second sub-layer, wherein both the first sub-layer and the second sub-layer comprise said electrically insulating matrix and, disposed in said electrically insulating matrix, said carbon nanotubes functionalized with a semiconducting polymer, wherein the concentration of the carbon nanotubes functionalized with a semiconducting polymer is greater in the first sub-layer than in the second sub-layer.

7. A photovoltaic device according to claim 6 which comprises a photoactive region disposed between a first electrode and a second electrode, which photoactive region comprises said charge-transporting layer and a photoactive material, and preferably wherein the photoactive material is in contact with said charge-transporting layer.

8. A photovoltaic device according to claim 7 wherein the photoactive region comprises:
(a) said charge-transporting layer;
(b) said photoactive material; and
(c) a mesoporous scaffold layer, comprising a mesoporous dielectric scaffold material or a mesoporous charge-transporting scaffold material,
wherein the photoactive material is disposed between said charge-transporting layer and the mesoporous scaffold layer, and preferably wherein the photoactive material is disposed in pores of the mesoporous scaffold layer.

9. A photovoltaic device according to claim 7 or claim 8 wherein the photoactive region comprises:
(a) an n-type region comprising at least one layer of an n-type material;
(b) a p-type region comprising at least one layer of a p-type material; and, disposed between the n-type region and the p-type region:
(c) a layer of the photoactive material,
wherein said charge-transporting layer is a layer of a p-type material in said p-type region or a layer of an n-type material in said n-type region, and preferably wherein said charge-transporting layer is a layer of a p-type material in said p-type region.

10. A photovoltaic device according to claim 9 wherein the layer of the photoactive material forms a planar heterojunction with the n-type region or the p-type region, or wherein the layer of the photoactive material forms a first planar heterojunction with the n-type region and a second planar heterojunction with the p-type region.

11. A process for producing a photovoltaic device according to claim 1, which photovoltaic device comprises a component for transporting charge, which component comprises an electrically insulating matrix and, disposed in said matrix, carbon nanotubes functionalized with a semiconducting polymer, which process comprises:
(a) providing a substrate and, disposed on a surface of the substrate, carbon nanotubes functionalized with a semiconducting polymer; and
(b) disposing an electrically insulating matrix onto the carbon nanotubes functionalized with a semiconducting polymer.

12. A process according to claim 11 which comprises:
(a) disposing said carbon nanotubes functionalized with a semiconducting polymer on the surface of the substrate; and
(b) disposing an electrically insulating matrix onto the carbon nanotubes functionalized with a semiconducting polymer.

13. A process according to claim 11 or claim 12 which further comprises producing the carbon nanotubes functionalized with a semiconducting polymer by:
(i) preparing a composition comprising carbon nanotubes, a solvent and, dissolved in the solvent, said semiconducting polymer;
(ii) agitating the composition, optionally by sonicating the composition;
(iii) separating solid material from the composition, which solid material comprises non-functionalized carbon nanotubes and carbonaceous particles, and recovering the supernatant;
(iv) treating the supernatant to induce aggregation of carbon nanotubes functionalized with the semiconducting polymer, optionally by heating the supernatant and/or by adding a further solvent to the supernatant;
(v) recovering the aggregated carbon nanotubes functionalized with the semiconducting polymer;
(vi) washing the carbon nanotubes functionalized with the semiconducting polymer with a solvent, to remove any free semiconducting polymer;
(vii) recovering the carbon nanotubes functionalized with the semiconducting polymer; and
(viii) optionally repeating (vi) and (vii).

14. A process according to any one of claims 11 to 13 wherein the electrically insulating matrix is as defined in claim 3 and the carbon nanotubes functionalized with a semiconducting polymer are as defined in claim 4 or claim 5.

15. A process according to any one of claims 11 to 13 wherein the electrically insulating matrix comprises an electrically insulating organic polymer and the step of (b) disposing an electrically insulating matrix onto the carbon nanotubes functionalized with a semiconducting polymer comprises:
(b1) disposing onto said carbon nanotubes functionalized with a semiconducting polymer a composition comprising one or more monomers suitable for producing an electrically insulating organic polymer; and
(b2) polymerising said monomers, and thereby producing said electrically insulating organic polymer.

16. A process according to any one of claims 11 to 13 wherein the electrically insulating matrix comprises an electrically insulating organic polymer and the step of (b) disposing an electrically insulating matrix onto the carbon nanotubes functionalized with a semiconducting polymer comprises:
(b1) disposing onto said carbon nanotubes functionalized with a semiconducting polymer a composition comprising an uncured precursor to an electrically insulating organic polymer; and
(b2) curing said composition, and thereby producing said electrically insulating organic polymer.

17. A process according to any one of claims 11 to 16 wherein the step of (b) disposing an electrically insulating matrix onto the carbon nanotubes functionalized with a semiconducting polymer comprises:
- disposing the electrically insulating matrix onto the carbon nanotubes to form a first sub-layer, which first sub-layer comprises said electrically insulating matrix and, disposed in said electrically insulating matrix at a first concentration, said carbon nanotubes functionalized with a semiconducting polymer; and
- continuing to dispose the electrically insulating matrix to form a second sub layer on the first sub-layer, wherein the second sub-layer comprises said electrically insulating matrix and, disposed in said electrically insulating matrix at a second concentration, said carbon nanotubes functionalized with a semiconducting polymer,
wherein the second concentration is less than the first concentration.

## Patentansprüche

1. Fotovoltaische Vorrichtung, umfassend eine Komponente zum Transportieren von Ladung, wobei die Komponente eine elektrisch isolierende Matrix und angeordnet in der Matrix, Kohlenstoffnanoröhren, die mit einem halbleitenden Polymer funktionalisiert sind, umfasst.

2. Fotovoltaische Vorrichtung nach Anspruch 1, wobei die Kohlenstoffnanoröhren, die mit einem halbleitenden Polymer funktionalisiert sind, innerhalb der elektrisch isolierenden Matrix dispergiert sind und bevorzugt innerhalb der elektrisch isolierenden Matrix zufällig dispergiert sind und bevorzugter innerhalb eines Bereichs oder einer Unterschicht der elektrisch isolierenden Matrix oder innerhalb der gesamten elektrisch isolierenden Matrix zufällig dispergiert sind.

3. Fotovoltaische Vorrichtung nach Anspruch 1 oder Anspruch 2, wobei die elektrisch isolierende Matrix ein elektrisch isolierendes organisches Material oder ein dielektrisches anorganisches Material umfasst, bevorzugt ein elektrisch isolierendes organisches Polymer umfasst und bevorzugter ein Poly(acrylat), ein Poly(methacrylat), einen Polyvinylalkohol, ein Polystyrol, ein Polybutyrat, ein Polyimid oder ein Polycarbonat umfasst.

4. Fotovoltaische Vorrichtung nach einem der Ansprüche 1 bis 3, wobei die Kohlenstoffnanoröhren mindestens teilweise mit dem halbleitenden Polymer beschichtet sind und bevorzugt in das halbleitende Polymer eingewickelt sind.

5. Fotovoltaische Vorrichtung nach einem der vorhergehenden Ansprüche, wobei das halbleitende Polymer ein konjugiertes Polymer und/oder ein lochtransportierendes Polymer ist und bevorzugt ein Polythiophen, wie z. B. Poly(3-hexylthiophen), Poly(3-octylthiophen) oder Poly(3-dodecylthiophen), ein Polyfluoren, wie z. B. Poly(9,9-dioctofluoren), Poly(9,9-di-n-octylfluoren-alt-benzothiadiazol) oder Poly(indenofluoren), oder ein Poly(phenylenvinylen) umfasst.

6. Fotovoltaische Vorrichtung nach einem der vorhergehenden Ansprüche, wobei die Komponente zum Transportieren von Ladung eine ladungstransportierende Schicht umfasst und bevorzugt wobei die ladungstransportierende Schicht eine erste Unterschicht in Kontakt mit einer zweiten Unterschicht umfasst, wobei sowohl die erste Unterschicht als auch die zweite Unterschicht die elektrisch isolierende Matrix und angeordnet in der elektrisch isolierenden Matrix, die Kohlenstoffnanoröhren, die mit einem halbleitenden Polymer funktionalisiert sind, umfassen, wobei die Konzentration der Kohlenstoffnanoröhren, die mit einem halbleitenden Polymer funktionalisiert sind, in der ersten Unterschicht größer als in der zweiten Unterschicht ist.

7. Fotovoltaische Vorrichtung nach Anspruch 6, die einen fotoaktiven Bereich, der zwischen einer ersten Elektrode und einer zweiten Elektrode angeordnet ist, umfasst, wobei der fotoaktive Bereich die ladungstransportierende Schicht und ein fotoaktives Material umfasst und bevorzugt wobei das fotoaktive Material in Kontakt mit der ladungstransportierenden Schicht ist.

8. Fotovoltaische Vorrichtung nach Anspruch 7, wobei der fotoaktive Bereich Folgendes umfasst:
(a) die ladungstransportierende Schicht;
(b) das fotoaktive Material; und
(c) eine mesoporöse Gerüstschicht, umfassend ein mesoporöses dielektrisches Gerüstmaterial oder ein mesoporöses ladungstransportierendes Gerüstmaterial,
wobei das fotoaktive Material zwischen der ladungstransportierenden Schicht und der mesoporösen Gerüstschicht angeordnet ist und bevorzugt wobei das fotoaktive Material in Poren der mesoporösen Gerüstschicht angeordnet ist.

9. Fotovoltaische Vorrichtung nach Anspruch 7 oder Anspruch 8, wobei der fotoaktive Bereich Folgendes umfasst:
(a) einen n-Typ-Bereich, umfassend mindestens eine Schicht eines n-Typ-Materials;
(b) einen p-Typ Bereich, umfassend mindestens eine Schicht eines p-Typ-Materials; und angeordnet zwischen dem n-Typ-Bereich und dem p-Typ-Bereich:
(c) eine Schicht des fotoaktiven Materials,
wobei die ladungstransportierende Schicht eine Schicht aus einem p-Typ-Material in dem p-Typ-Bereich oder eine Schicht aus einem n-Typ-Material in dem n-Typ-Bereich ist und bevorzugt wobei die ladungstransportierende Schicht eine Schicht aus einem p-Typ-Material in dem p-Typ-Bereich ist.

10. Fotovoltaische Vorrichtung nach Anspruch 9, wobei die Schicht des fotoaktiven Materials einen planaren Heteroübergang mit dem n-Typ-Bereich oder dem p-Typ-Bereich bildet oder wobei die Schicht des fotoaktiven Materials einen ersten planaren Heteroübergang mit dem n-Typ-Bereich und einen zweiten planaren Heteroübergang mit dem p-Typ-Bereich bildet.

11. Prozess zum Produzieren einer fotovoltaischen Vorrichtung nach Anspruch 1, wobei die fotovoltaische Vorrichtung eine Komponente zum Transportieren von Ladung umfasst, wobei die Komponente eine elektrisch isolierende Matrix und angeordnet in der Matrix, Kohlenstoffnanoröhren, die mit einem halbleitenden Polymer funktionalisiert sind, umfasst, wobei der Prozess Folgendes umfasst:
(a) Bereitstellen von einem Substrat und angeordnet auf einer Oberfläche des Substrats, Kohlenstoffnanoröhren, die mit einem halbleitenden Polymer funktionalisiert sind; und
(b) Anordnen einer elektrisch isolierenden Matrix auf den Kohlenstoffnanoröhren, die mit einem halbleitenden Polymer funktionalisiert sind.

12. Prozess nach Anspruch 11, der Folgendes umfasst:
(a) Anordnen der Kohlenstoffnanoröhren, die mit einem halbleitenden Polymer funktionalisiert sind, auf der Oberfläche des Substrats; und
(b) Anordnen einer elektrisch isolierenden Matrix auf den Kohlenstoffnanoröhren, die mit einem halbleitenden Polymer funktionalisiert sind.

13. Prozess nach Anspruch 11 oder Anspruch 12, der ferner Produzieren der Kohlenstoffnanoröhren, die mit einem halbleitenden Polymer funktionalisiert sind, durch Folgendes umfasst:
(i) Herstellen einer Zusammensetzung, umfassend Kohlenstoffnanoröhren, ein Lösungsmittel und gelöst in dem Lösungsmittel, das halbleitende Polymer;
(ii) Rühren der Zusammensetzung, optional durch Beschallung der Zusammensetzung;
(iii) Trennen von festem Material von der Zusammensetzung, wobei das feste Material nicht-funktionalisierte Kohlenstoffnanoröhren und kohlenstoffhaltige Teilchen umfasst, und Rückgewinnen des Überstands;
(iv) Behandeln des Überstands, um Aggregation von Kohlenstoffnanoröhren, die mit dem halbleitenden Polymer funktionalisiert sind, zu induzieren, optional durch Erhitzen des Überstands und/oder durch Zugeben eines weiteren Lösungsmittels zu dem Überstand;
(v) Rückgewinnen der aggregierten Kohlenstoffnanoröhren, die mit dem halbleitenden Polymer funktionalisiert sind;
(vi) Waschen der Kohlenstoffnanoröhren, die mit dem halbleitenden Polymer funktionalisiert sind, mit einem Lösungsmittel, um alle freien halbleitenden Polymere zu entfernen;
(vii) Rückgewinnen der Kohlenstoffnanoröhren, die mit dem halbleitenden Polymer funktionalisiert sind; und
(viii) optionales Wiederholen von (vi) und (vii).

14. Prozess nach einem der Ansprüche 11 bis 13, wobei die elektrisch isolierende Matrix wie definiert in Anspruch 3 ist und die Kohlenstoffnanoröhren, die mit einem halbleitenden Polymer funktionalisiert sind, wie definiert in Anspruch 4 oder Anspruch 5 sind.

15. Prozess nach einem der Ansprüche 11 bis 13, wobei die elektrisch isolierende Matrix ein elektrisch isolierendes organisches Polymer umfasst und der Schritt von (b) Anordnen einer elektrisch isolierenden Matrix auf den Kohlenstoffnanoröhren, die mit einem halbleitenden Polymer funktionalisiert sind, Folgendes umfasst:
(b1) auf den Kohlenstoffnanoröhren, die mit einem halbleitenden Polymer funktionalisiert sind, Anordnen einer Zusammensetzung, umfassend ein oder mehrere Monomere, die zum Produzieren eines elektrisch isolierenden organischen Polymers geeignet sind; und
(b2) Polymerisieren der Monomere und dadurch Produzieren des elektrisch isolierenden organischen Polymers.

16. Prozess nach einem der Ansprüche 11 bis 13, wobei die elektrisch isolierende Matrix ein elektrisch isolierendes organisches Polymer umfasst und der Schritt von (b) Anordnen einer elektrisch isolierenden Matrix auf den Kohlenstoffnanoröhren, die mit einem halbleitenden Polymer funktionalisiert sind, Folgendes umfasst:
(b1) auf den Kohlenstoffnanoröhren, die mit einem halbleitenden Polymer funktionalisiert sind, Anordnen einer Zusammensetzung, umfassend einen ungehärteten Vorläufer eines elektrisch isolierenden organischen Polymers; und
(b2) Härten der Zusammensetzung und dadurch Produzieren des elektrisch isolierenden organischen Polymers.

17. Prozess nach einem der Ansprüche 11 bis 16, wobei der Schritt von (b) Anordnen einer elektrisch isolierenden Matrix auf den Kohlenstoffnanoröhren, die mit einem halbleitenden Polymer funktionalisiert sind, Folgendes umfasst:
- Anordnen der elektrisch isolierenden Matrix auf den Kohlenstoffnanoröhren, um eine erste Unterschicht zu bilden, wobei die erste Unterschicht die elektrisch isolierende Matrix und angeordnet in der elektrisch isolierenden Matrix in einer ersten Konzentration, die Kohlenstoffnanoröhren, die mit einem halbleitenden Polymer funktionalisiert sind, umfasst; und
- Fortsetzen eines Anordnens der elektrisch isolierenden Matrix, um eine zweite Unterschicht auf der ersten Unterschicht zu bilden, wobei die zweite Unterschicht die elektrisch isolierende Matrix und angeordnet in der elektrisch isolierenden Matrix in einer zweiten Konzentration, die Kohlenstoffnanoröhren, die mit einem halbleitenden Polymer funktionalisiert sind, umfasst,
wobei die zweite Konzentration weniger als die erste Konzentration ist.

## Revendications

1. Dispositif photovoltaïque comprenant un composant de transport de charges, lequel composant comprend une matrice électriquement isolante et, disposé dans ladite matrice, des nanotubes de carbone fonctionnalisés avec un polymère semi-conducteur.

2. Dispositif photovoltaïque selon la revendication 1, dans lequel les nanotubes de carbone fonctionnalisés avec un polymère semi-conducteur sont dispersés au sein de la matrice électriquement isolante, et de préférence sont dispersés de manière aléatoire au sein de la matrice électriquement isolante, et plus préférentiellement sont dispersés au hasard au sein d'une région ou sous-couche de la matrice électriquement isolante, ou dans l'ensemble de la matrice électriquement isolante.

3. Dispositif photovoltaïque selon la revendication 1 ou la revendication 2, dans lequel la matrice électriquement isolante comprend un matériau organique électriquement isolant, ou un matériau inorganique diélectrique, comprend de préférence un polymère organique électriquement isolant, et plus préférablement comprend un poly(acrylate), un poly(méthacrylate), un alcool polyvinylique, un polystyrène, un polybutyrate, un polyimide ou un polycarbonate.

4. Dispositif photovoltaïque selon l'une quelconque des revendications 1 à 3, dans lequel lesdits nanotubes de carbone sont recouverts au moins en partie du polymère semi-conducteur, et de préférence sont enveloppés dans le polymère semi-conducteur.

5. Dispositif photovoltaïque selon l'une quelconque des revendications précédentes, dans lequel le polymère semi-conducteur est un polymère conjugué et / ou un polymère transporteur de trous, et comprend de préférence un polythiophène, tel que le poly(3-hexylthiophène), poly(3-octylthiophène) ou poly(3-dodécylthiophène) ; un polyfluorène, tel que le poly(9,9-dioctofluorène), le poly(9,9-di-n-octylfluorène-alt-benzothiadiazole) ou le poly (indénofluorène) ; ou un poly (phénylène vinylène).

6. Dispositif photovoltaïque selon l'une quelconque des revendications précédentes, dans lequel le composant de transport de charge est une couche de transport de charge, et de préférence dans lequel ladite couche de transport de charge comprend une première sous-couche en contact avec une deuxième sous-couche, dans laquelle à la fois la première sous-couche et la deuxième sous-couche comprennent ladite matrice électriquement isolante et, disposées dans ladite matrice électriquement isolante, lesdits nanotubes de carbone fonctionnalisés avec un polymère semi-conducteur, dans lequel la concentration des nanotubes de carbone fonctionnalisés avec un polymère semi-conducteur est plus grande dans la première sous-couche que dans la deuxième sous-couche.

7. Dispositif photovoltaïque selon la revendication 6, comprenant une région photoactive disposée entre une première électrode et une seconde électrode, laquelle région photoactive comprend ladite couche de transport de charges et un matériau photoactif, et de préférence dans lequel le matériau photoactif est en contact avec ladite couche de transport de charges.

8. Dispositif photovoltaïque selon la revendication 7, dans lequel la région photoactive comprend :
(a) ladite couche de transport de charges ;
(b) ledit matériau photoactif ; et
(c) une couche d'échafaudage mésoporeuse, comprenant un matériau d'échafaudage diélectrique mésoporeux ou un matériau d'échafaudage de transport de charges mésoporeux,
dans lequel le matériau photoactif est disposé entre ladite couche de transport de charges et la couche d'échafaudage mésoporeuse, et de préférence dans lequel le matériau photoactif est disposé dans les pores de la couche d'échafaudage mésoporeuse.

9. Dispositif photovoltaïque selon la revendication 7 ou la revendication 8, dans lequel la région photoactive comprend :
(a) une région de type n comprenant au moins une couche d'un matériau de type n;
(b) une région de type p comprenant au moins une couche d'un matériau de type p; et, disposé entre la région de type n et la région de type p :
(c) une couche de matière photoactive,
dans lequel ladite couche de transport de charges est une couche d'un matériau de type p dans ladite région de type p ou une couche d'un matériau de type n dans ladite région de type n, et de préférence dans laquelle ladite couche de transport de charge est une couche d'un matériau de type p dans ladite région de type p.

10. Dispositif photovoltaïque selon la revendication 9, dans lequel la couche du matériau photoactif forme une hétérojonction plane avec la région de type n ou la région de type p, ou dans lequel la couche du matériau photoactif forme une première hétéroj onction plane avec la région de type n et une seconde hétérojonction plane avec la région de type p.

11. Procédé de fabrication d'un dispositif photovoltaïque selon la revendication 1, lequel dispositif photovoltaïque comprend un composant de transport de charges, lequel composant comprend une matrice électriquement isolante et, disposé dans ladite matrice, des nanotubes de carbone fonctionnalisés avec un polymère semi-conducteur, lequel procédé comprend :
(a) la fourniture d'un substrat et, disposés sur une surface du substrat, des nanotubes de carbone fonctionnalisés avec un polymère semi-conducteur; et
(b) la disposition d'une matrice électriquement isolante sur les nanotubes de carbone fonctionnalisés avec un polymère semi-conducteur.

12. Procédé selon la revendication 11, comprenant :
(a) la disposition desdits nanotubes de carbone fonctionnalisés avec un polymère semi-conducteur sur la surface du substrat; et
(b) la disposition d'une matrice électriquement isolante sur les nanotubes de carbone fonctionnalisés avec un polymère semi-conducteur.

13. Procédé selon la revendication 11 ou la revendication 12, comprenant en outre la production des nanotubes de carbone fonctionnalisés avec un polymère semi-conducteur par :
(i) préparation d'une composition comprenant des nanotubes de carbone, un solvant et, dissous dans le solvant, ledit polymère semi-conducteur ;
(ii) agitation de la composition, éventuellement par sonication de la composition ;
(iii) séparation du matériau solide de la composition, lequel matériau solide comprend des nanotubes de carbone non fonctionnalisés et des particules carbonées, et récupération du surnageant ;
(iv) traitement du surnageant pour induire une agrégation de nanotubes de carbone fonctionnalisés avec le polymère semi-conducteur, éventuellement en chauffant le surnageant et / ou en ajoutant un autre solvant au surnageant ;
(v) récupération des nanotubes de carbone agrégés fonctionnalisés avec le polymère semi-conducteur ;
(vi) lavage des nanotubes de carbone fonctionnalisés avec le polymère semi-conducteur avec un solvant, pour éliminer tout polymère semi-conducteur libre ;
(vii) récupération des nanotubes de carbone fonctionnalisés avec le polymère semi-conducteur; et
(viii) répéter éventuellement (vi) et (vii).

14. Procédé selon l'une quelconque des revendications 11 à 13, dans lequel la matrice électriquement isolante est telle que définie dans la revendication 3 et les nanotubes de carbone fonctionnalisés avec un polymère semi-conducteur sont tels que définis dans la revendication 4 ou la revendication 5.

15. Procédé selon l'une quelconque des revendications 11 à 13, dans lequel la matrice électriquement isolante comprend un polymère organique électriquement isolant et l'étape de (b) disposer une matrice électriquement isolante sur les nanotubes de carbone fonctionnalisés avec un polymère semi-conducteur comprend :
(b1) la disposition sur lesdits nanotubes de carbone fonctionnalisés avec un polymère semi-conducteur d'une composition comprenant un ou plusieurs monomères appropriés pour produire un polymère organique électriquement isolant; et
(b2) la polymérisation desdits monomères, et ainsi la production dudit polymère organique électriquement isolant.

16. Procédé selon l'une quelconque des revendications 11 à 13, dans lequel la matrice électriquement isolante comprend un polymère organique électriquement isolant et l'étape de (b) disposer une matrice électriquement isolante sur les nanotubes de carbone fonctionnalisés avec un polymère semi-conducteur comprend :
(b1) la disposition sur lesdits nanotubes de carbone fonctionnalisés avec un polymère semi-conducteur d'une composition comprenant un précurseur non durci d'un polymère organique électriquement isolant; et
(b2) le durcissement de ladite composition, et ainsi la production dudit polymère organique électriquement isolant.

17. Procédé selon l'une quelconque des revendications 11 à 16 dans lequel l'étape de (b) disposer une matrice électriquement isolante sur les nanotubes de carbone fonctionnalisés avec un polymère semi-conducteur comprend :
- la disposition de la matrice électriquement isolante sur les nanotubes de carbone pour former une première sous-couche, laquelle première sous-couche comprend ladite matrice électriquement isolante et, disposée dans ladite matrice électriquement isolante à une première concentration, lesdits nanotubes de carbone fonctionnalisés avec un polymère semi-conducteur; et
- continuer à disposer la matrice électriquement isolante pour former une deuxième sous-couche sur la première sous-couche, dans laquelle la deuxième sous-couche comprend ladite matrice électriquement isolante et, disposée dans ladite matrice électriquement isolante à une deuxième concentration, lesdits nanotubes de carbone fonctionnalisés avec un polymère semi-conducteur,
dans lequel la deuxième concentration est inférieure à la première concentration.
